# EUROPÄISCHE PATENTANMELDUNG

(11) **EP 3 421 638 A1**
(43) Veröffentlichungstag der Anmeldung: **02.01.2019**
(21) Anmeldenummer: 17178282.4
(22) Anmeldetag: 28.06.2017
(51) Int. Cl.: C23C 16/44, C23C 16/458, C23C 16/509

(54) **VORRICHTUNG ZUR HOCHTEMPERATUR-CVD MIT EINER STAPELANORDNUNG AUS GASVERTEILERN UND AUFNAHMEPLATTEN**

(71) Anmelder: Meyer Burger (Germany) GmbH, 09337 Hohenstein-Ernstthal (DE)
(72) Erfinder: Schlemm, Hermann, 07751 Milda (DE); Helbig, Stefan, 04626 Schmölln (DE); Ansorge, Erik, 09127 Chemnitz (DE); Frendel, Christian, 08451 Crimmitschau (DE); Pietzsch, Rocco, 08064 Zwickau (DE)
(74) Vertreter: Kailuweit & Uhlemann Patentanwälte Partnerschaft mbB

(57) **Zusammenfassung**

Die Erfindung betrifft eine Hochtemperatur-CVD-Vorrichtung, die mehrere Paare bestehend aus je einem Gasverteiler und einer Aufnahmeplatte aufweist. Dabei liegen sich in jedem Paar der Gasverteiler und die Aufnahmeplatte gegenüber und begrenzen einen zugehörigen Prozessraum. In jedem Paar ist der Gasverteiler geeignet, ein Gas in den Prozessraum einzuleiten, während die Aufnahmeplatte geeignet ist, ein Substrat während der Gasphasenabscheidung zu halten. Alle Paare der Vorrichtung sind hintereinander entlang einer geraden Linie so angeordnet, dass die Linie in jedem Paar einer Verbindungslinie zwischen Gasverteiler und Aufnahmeplatte entspricht. Dabei sind die Gasverteiler und die Aufnahmeplatten alternierend angeordnet. Des Weiteren betrifft die Erfindung ein Verfahren zum Betreiben einer spezifischen Ausführungsform einer solchen Vorrichtung. Dabei werden nach dem Ausführen einer Vielzahl von Hochtemperatur-CVD-Prozessen ein plasmaunterstützter Reinigungsprozess unter Nutzung eines fluor- und/oder chlorhaltigen Prozessgases und anschließend ein Konditionierungsprozess durchgeführt.

## Beschreibung

Die Erfindung betrifft eine Vorrichtung, die zur Durchführung eines Hochtemperatur-CVD-Prozesses geeignet ist und eine Stapelanordnung aus Gasverteilern und Aufnahmeplatten aufweist.

In der Solarzellenherstellung, der Mikroelektronik oder bei der Veredlung von Substratoberflächen (z. B. Glas) werden verschiedene Prozesse zur Abscheidung von Schichten oder Partikeln auf der Oberfläche eines Substrates genutzt. Bei der chemischen Gasphasenabscheidung (CVD, Chemical Vapour Deposition) werden dabei ein oder mehrere Prozessgase in einen an die zu beschichtende Oberfläche des Substrats angrenzenden Prozessraum eingeleitet. Mindestens eines der Prozessgase reagiert dabei an der Oberfläche des Substrates und bildet auf ihr eine feste Schicht. Dabei wird das Substrat auf einer Aufnahmeplatte, auch Suszeptor genannt, während der Abscheidung gehalten. Dabei liegt das Substrat oder ein Substrathalter, auf dem das Substrat angeordnet ist, mit seiner Rückseite auf der Aufnahmeplatte auf oder an dieser an. Bei Hochtemperatur-CVD-Prozessen wird die Erzeugung fester Schichtbestandteile durch eine hohe Temperatur über 600°C, insbesondere eine Temperatur zwischen 700°C und 1100°C, erreicht, d.h. die chemische Reaktion wird thermisch aktiviert, wobei die hohe Temperatur meist direkt an der Substratoberfläche eingestellt wird. Oftmals wird dazu das Substrat über eine geheizte Aufnahmeplatte erwärmt, mit welcher es hauptsächlich über seine Rückseite thermisch leitend verbunden ist Ein Beispiel für einen solchen Hochtemperatur-CVD-Prozess ist die metallorganische chemische Gasphasenabscheidung (MOCVD) von Galliumarsenid (GaAs) oder Siliziumgermanium (SiGe). Meist werden flächige Substrate behandelt, welche eine große Fläche in einer Ebene und eine demgegenüber nur geringe Dicke oder Höhe in einer Richtung senkrecht zu dieser Ebene aufweisen. So weisen beispielsweise Solarzellensubstrate eine Fläche von (156 x 156) mm² bei einer Substratdicke zwischen 140 µm und 200 µm auf. Dabei wird die zu beschichtende flächige Oberfläche des Substrats Substratvorderseite und die dieser gegenüberliegendeandere flächige Oberfläche des Substrats Substratrückseite genannt.

Um eine homogene Abscheidung von Schichten auf der Substratoberfläche und eine hohe Abscheiderate zu gewährleisten, werden die Prozessgase oftmals über einen sogenannten Gasverteiler (showerhead) mit vielen, über die der Substratoberfläche zugewandte Oberfläche verteilte Gasaustrittsöffnungen dem Prozessraum zugeführt, wobei eine hohe Parallelität zwischen den an den Prozessraum angrenzenden Oberflächen des Gasverteilers und des Substrats vorteilhaft ist.

Aus dem Stand der Technik sind sowohl horizontale Anordnungen von MOCVD-Anlagen, bei denen sich die an den Prozessraum angrenzenden Oberflächen des Gasverteilers und des Substrats in einer horizontalen Ebene erstrecken, als auch vertikale Anordnungen dieser Oberflächen bekannt. Beide Konzepte sind bspw. in der EP 3 061 845 A2 beschrieben.

Um den Durchsatz von Substraten bei einer Hochtemperatur-CVD-Behandlung zu erhöhen, werden batch-Systeme, in denen mehrere Substrate gleichzeitig behandelt werden, verwendet. Dabei sind die Substrate mit der zu beschichteten Oberfläche in einer Ebene nebeneinander auf einer oder mehreren Aufnahmeplatten angeordnet, wobei ihnen ein entsprechend großflächiger Gasverteiler oder mehrere ebenfalls in einer Ebene nebeneinander angeordnete Gasverteiler gegenüberliegen. Dies ist bspw. in der EP 3 061 845 A2 beschrieben. Bei großflächigen Anordnungen von Substraten in einer Ebene und/oder einem großflächigen Gasverteiler stellt die notwendige Parallelität der Oberfläche der Substrate und des Gasverteilers eine große Herausforderung dar. Darüber hinaus wird die Anzahl der gleichzeitig behandelbaren Substrate durch die resultierende Größe einer Prozesskammer und die damit verbundenen Herausforderungen, z.B. beim Erzeugen eines für den CVD-Prozess notwendigen Drucks innerhalb der Kammer, begrenzt.

Die ebenfalls in der EP 3 061 845 A2 beschriebene Anordnung von zwei hintereinander angeordneten Einheiten aus Gasverteiler und Aufnahmeplatte, bei der die Gasverteiler in der Mitte der Bearbeitungskammer und die Aufnahmeplatten angrenzend an die Wand der Prozesskammer angeordnet sind, ist nicht auf mehr als zwei Einheiten erweiterbar. Darüber hinaus stellt die unterschiedliche Strömungsrichtung der Gase zwischen Gasverteiler und Substratoberfläche innerhalb der Kammer eine große Herausforderung bezüglich der erreichbaren Homogenität der Schichten zwischen den einzelnen Einheiten dar.

Auch das Betreiben einer solchen Hochtemperatur-CVD-Anlage ist mit verschiedenen Problemen behaftet. Während der Beschichtung von Substraten werden auch alle anderen Flächen in der Prozesskammer, die eine entsprechend hohe Temperatur aufweisen und bis zu denen die Prozessgase gelangen, beschichtet. Auch auf anderen Flächen, die eine niedrigere Temperatur aufweisen, können sich Partikel absetzen. Sowohl die parasitären Beschichtungen als auch die Partikel können die Qualität der auf den Substraten abgeschiedenen Schichten oder den Betrieb der gesamten Vorrichtung beeinträchtigen. Daher ist von Zeit zu Zeit eine Reinigung der Prozesskammer und insbesondere des Gasverteilers und der Aufnahmeplatte notwendig.

Aufgabe der vorliegenden Anmeldung ist es, eine alternative Hochtemperatur-CVD-Vorrichtung zur Verfügung zu stellen, mit der bei geringem Platzbedarf eine hohe Homogenität der Beschichtung für die mehreren Substrate sowie eine hohe Anzahl gleichzeitig behandelbarer Substrate erreichbar ist. Darüber hinaus ist es Aufgabe der vorliegenden Anmeldung, ein Betriebsverfahren für eine besondere Ausführungsform einer solchen Vorrichtung bereitzustellen. Die Aufgabe wird gelöst durch eine Hochtemperatur-CVD-Vorrichtung gemäß Anspruch 1 und ein Betriebsverfahren gemäß Anspruch 17. Bevorzugte Ausführungsformen finden sich in den Unteransprüchen.

Die erfindungsgemäße Vorrichtung zur chemischen Gasphasenabscheidung bei hohen Temperaturen (Hochtemperatur-CVD-Vorrichtung) weist mehrere Paare bestehend aus je einem Gasverteiler und einer Aufnahmeplatte auf. In jedem Paar liegen sich der Gasverteiler und die Aufnahmeplatte gegenüber und begrenzen einen zugehörigen Prozessraum. In jedem Paar ist der Gasverteiler geeignet, ein Gas in den Prozessraum einzuleiten, während die Aufnahmeplatte in jedem Paar geeignet ist, ein Substrat, auf dessen Oberfläche eine Schicht mittels der chemischen Gasphasenabscheidung bei hohen Temperaturen abgeschieden werden soll, während der Abscheidung zu halten. Selbstverständlich können auch mehrere Substrate gleichzeitig auf einer Aufnahmeplatte gehalten werden, bspw. 4 oder 9 Substrate. Damit liegen sich in einem Paar diejenige Oberfläche des Gasverteilers, aus der ein Gas in den Prozessraum eingeleitet wird, im Folgenden Gasaustrittsoberfläche genannt, und diejenige Oberfläche der Aufnahmeplatte, auf der das Substrat während der Abscheidung angeordnet ist, im Folgenden Substrathalteoberfläche genannt, gegenüber. Vorzugsweise sind diese Oberflächen parallel zueinander. Alle Paare sind hintereinander entlang einer geraden Linie so angeordnet, dass die Linie in jedem Paar einer Verbindungslinie zwischen Gasverteiler und Aufnahmeplatte entspricht. Die Verbindungslinie zwischen Gasverteiler und Aufnahmeplatte verbindet dabei vorzugsweise die Mittelpunkte der Gasaustrittsoberfläche und der Substrathalteoberfläche miteinander. Die Gasverteiler und die Aufnahmeplatten sind alternierend angeordnet. Das heißt, entlang der Linie sind jeweils abwechselnd ein Gasverteiler und eine Aufnahmeplatte angeordnet. Diese Anordnung des Gasverteilers und der Aufnahmeplatte innerhalb jedes Paares sowie der Paare insgesamt innerhalb der Vorrichtung ermöglicht eine besonders gleichförmige (homogene) Beschichtung aller gleichzeitig in der Anlage beschichteten Substrate. Durch die Aufnahmeplatte und den Gasverteiler, die jeweils zwischen benachbarten Prozessräumen angeordnet sind, sind die einzelnen Prozessräume eindeutig voneinander abgegrenzt. Damit ergeben sich Möglichkeiten, die Bedingungen in bestimmten Prozessräumen, beispielsweise in den an den beiden Enden der Linie angeordneten Prozessräumen, so einzustellen und anzupassen, beispielsweise hinsichtlich der Gaszusammensetzung und/oder der Gasmenge und/oder der Temperatur der Aufnahmeplatte, dass für die einzelnen Paare der Vorrichtung vorliegende Randbedingungen in einer Prozesskammer, in der die Vorrichtung angeordnet ist, gut zwischen den einzelnen Paaren ausgeglichen werden können. Die Prozesskammer ermöglicht die Bereitstellung definierter Umgebungsbedingungen für die Vorrichtung zur chemischen Gasphasenabscheidung bei hohen Temperaturen und für eine große Anzahl gleichzeitig behandelter Substrate.

Die Anzahl der Paare aus Gasverteiler und Aufnahmeplatte ist nicht begrenzt Vorzugsweise liegt sie zwischen 4 und 50 Paaren, besonders bevorzugt zwischen 10 und 25 Paaren. In diesen Bereichen sind die Anforderungen an die Prozesskammer hinsichtlich mechanischer Stabilität, Zu- und Abführung der Gase sowie weiterer Faktoren bei gleichzeitig erhöhtem Durchsatz gut umsetzbar.

In einer Ausführungsform erstreckt sich die Linie, entlang der die Paare angeordnet sind, in vertikaler Richtung. Dabei ist in jedem Paar der Gasverteiler oberhalb der Aufnahmeplatte angeordnet. Mit anderen Worten: die Gasaustrittsoberfläche und die Substrathalteoberfläche sind im Wesentlichen horizontal ausgerichtet. Damit kann das Substrat allein durch die Schwerkraft auf der Aufnahmeplatte gehalten werden, so dass weitere Halteelemente, die möglicherweise Spannungen in das Substrat einbringen, vermieden werden können.

In einer anderen Ausführungsform erstreckt sich die Linie, entlang der die Paare angeordnet sind, in horizontaler Richtung. Damit sind die Gasaustrittsoberfläche und die Substrathalteoberfläche im Wesentlichen vertikal ausgerichtet. Diese Ausführungsform stellt geringere Anforderungen bezüglich der mechanischen Stabilität an die Aufnahmeplatte als dies bei der horizontalen Ausrichtung der Substrathalteoberfläche der Fall ist. Damit kann die Wärmekapazität der Aufnahmeplatte, die neben der Auswahl des Materials der Aufnahmeplatte von den Abmessungen der Aufnahmeplatte, insbesondere der Dicke der Aufnahmeplatte abhängt, gegenüber der horizontal ausgerichteten Aufnahmeplatte verringert werden, so dassAufheiz- und Abkühlvorgänge der Aufnahmeplatte beschleunigt werden können. Darüber hinaus ist diese Ausführungsform durch eine geringere notwendige Dicke der Aufnahmeplatten platzsparend, wobei die Dicke entlang der Linie, entlang der die Paare angeordnet sind, gemessen wird.

In einer bevorzugten Ausführungsform enthält die Vorrichtung weiterhin mindestens eine Versorgungseinheit, die sich jeweils entlang einer Richtung, die parallel zu der Linie, entlang der die Paare angeordnet sind, ist, über mehrere Paare von Gasverteilern und Aufnahmeplatten erstreckt und auf einer Seite der Prozessräume angeordnet ist. Diese Versorgungseinheit ist dabei geeignet, mindestens eines der folgenden Medien den mehreren Paaren von Gasverteilern und Aufnahmeplatten zur Verfügung zu stellen oder aus diesen oder den jeweiligen Prozessräumen abzuführen: Kühlmedium zur Kühlung des Gasverteilers, Prozessgase zur Durchführung der chemischen Gasphasenabscheidung, flüchtige Reaktionsprodukte oder nicht umgesetzte Prozessgase, Heizmedium oder elektrischer Strom zum Heizen der Aufnahmeplatte, elektrisches Potential zur Beaufschlagung einer Plasmaelektrode. Das Kühlmedium ist vorzugsweise ein Kühlfluid, wie bspw. Wasser, Silikonöl oder andere geeignete Kühlflüssigkeiten. Das Heizmedium ist ebenfalls ein Fluid, wie bspw. Silikonöl oder andere geeignete Heizflüssigkeiten. Vorzugsweise wird die Aufnahmeplatte jedoch durch ein elektrisches Heizelement mittels elektrischem Strom geheizt, wobei die benötigten elektrischen Leitungen gegen die Prozessgase geschützt sind, z.B. durch entsprechende Verkleidungsmaterialien. Gleiches gilt auch für elektrische Leitungen zur Beaufschlagung von Potentialen. Vorzugsweise erstreckt sich die Versorgungseinheit über alle Paare von Gasverteilern und Aufnahmeplatten hinweg.

In einer besonderen Ausführungsform der Versorgungseinheit werden die Prozessgase einzeln oder gemeinsam über einen oder mehrere zweistufige Verteiler innerhalb der Versorgungseinheit zugeführt. Solch ein Verteiler weist dabei eine Zuführungsleitung, einen Verteilraum und genau so viele Auslassleitungen auf, wie Paare von der Versorgungseinheit mit Prozessgas versorgt werden. Die Zuführungsleitung ist geeignet, ein oder mehrere Prozessgase in den Verteilraum einzulassen. Im Verteilraum ist ein volumenreduzierender Block angeordnet, der den Verteilraum in einen Einlassraum, der mit der Zuführungsleitung verbunden ist, und einen Auslassraum, der mit den Auslassleitungen verbunden ist, unterteilt und eine Vielzahl von Durchlässen mit einem geringen Querschnitt zwischen dem Einlassraum und dem Auslassraum aufweist. Die Durchlässe sind vorzugsweise am äußeren Rand des Blocks angeordnet. Dadurch werden das oder die Prozessgase gleichmäßig über die gesamte Ausdehnung des Einlassraums verteilt und mit nahezu dem gleichen Druck in den Auslassraum durchgelassen. Damit verlassen das oder die Prozessgase den Auslassraum über die Auslassleitungen, von denen jede genau einem Gasverteiler zugeordnet ist, jeweils mit nahezu dem gleichen Druck. Damit kann auch bei einer großen Anzahl von Paaren von Gasverteilern und Aufnahmeplatten eine homogene Zuführung der Prozessgase erreicht werden.

In einer anderen besonderen Ausführungsform der Versorgungseinheit werden die Prozessgase einzeln oder gemeinsam über einen oder mehrere binäre Verteiler innerhalb der Versorgungseinheit zugeführt. Ein solcher binärer Verteiler besteht aus einer Zuführungsleitung, mindestens einem Teiler und einer Vielzahl von Auslassleitungen, wobei in jedem Teiler das oder die von genau einer zuführenden ersten Leitung zugeführten Prozessgase auf genau zwei abgehende zweite Leitungen gleich aufgeteilt werden. Die Teiler sind in n Ebenen zwischen der Zuführungsleitung und den Auslassleitungen angeordnet. In einer ersten Ebene ist die Zuführungsleitung die erste Leitung des Teilers und in der n. Ebene sind die zweiten Leitungen die Auslassleitungen. Jede zweite Leitung einer i. Ebene ist eine erste Leitung einer (i+1). Ebene. Dabei gilt: i ∈ N und 1≤i≤n und n ∈ N und n≥1. Damit können letztlich 2ⁿ (mit n ≥ 1) Gasverteiler über jeweils eine Auslassleitung, die den binären Verteiler verlässt, mit Prozessgasen versorgt werden, wobei in jeder dieser Auslassleitungen derselbe Druck der Prozessgase vorliegt.

Gleiche Ausgestaltungen sind auch für die Abführung der Reaktionsprodukte oder nicht umgesetzter Prozessgase aus den Prozessräumen möglich, wobei diese zunächst über Absaugeinrichtungen, die entlang des Umfangs der Gasverteileroberfläche angeordnet sind, in für jeden Gasverteiler separate Absaugleitungen abgeführt werden. Jedoch können die einzelnen Absaugeinrichtungen oder Absaugleitungen auch unterschiedlich für verschiedene Paare von Gasverteilern und Aufnahmeplatten sein, um bspw. Konvektionseffekte der heißen Prozessgase durch unterschiedliche Absaugleistungen je nach Lage eines entsprechenden Paares von Gasverteiler und Aufnahmeplatte innerhalb der Mehrzahl von Paaren auszugleichen.

In besonderen Ausführungsformen sind ähnliche Ausgestaltungen von Verteilsystemen auch für die Zu- und Abfuhr von Kühlfluiden und von Heizfluiden, wenn diese genutzt werden, vorgesehen. Zur Zuführung eines elektrischen Stroms oder Potentials kann ebenfalls ein binärer Verteiler eingesetzt werden.

In einer anderen bevorzugten Ausführungsform enthält die mindestens eine Versorgungseinheit keine Vorrichtung zum Abführen von Prozessgasen und flüchtigen Reaktionsprodukten aus den Prozessräumen wie oben beschrieben. In einer solchen Ausführungsform enthält die Vorrichtung zwei Gasabsaugeinrichtungen, die sich jeweils mit ihrer absaugenden Oberfläche, im Folgenden Absaugoberfläche genannt, entlang einer Richtung, die parallel zu der Linie, entlang der die Paare angeordnet sind, ist, über mehrere Paare von Gasverteilern und Aufnahmeplatten erstrecken und auf gegenüberliegenden Seiten der Prozessräume angeordnet sind. Die Gasabsaugeinrichtungen sind dabei geeignet, aus den Prozessräumen der mehreren Paare ein Gas abzusaugen. Damit können flüchtige Reaktionsprodukte und nicht umgesetzte Gasbestandteile aus den jeweiligen Prozessräumen zur Seite hin abgesaugt werden. Vorzugsweise erstrecken sich die Gasabsaugeinrichtungen über alle Paare von Gasverteilern und Aufnahmeplatten hinweg.

In einer besonderen Ausführungsform der Hochtemperatur-CVD-Vorrichtung enthält die Vorrichtung zusätzlich eine Plasmaelektrode je Paar von Gasverteiler und Aufnahmeplatte, die geeignet ist, in dem jeweiligen Prozessraum ein Plasma zu zünden und aufrechtzuerhalten. Die Plasmaelektroden dienen der Reinigung des Gasverteilers und/oder der Aufnahmeplatte während eines Reinigungsprozesses, wie er später beschrieben wird. Die Plasmaelektrode ist vorzugsweise angrenzend an die Gasaustrittsoberfläche des Gasverteilers angeordnet oder in diese integriert. In einer anderen bevorzugten Ausführungsform ist die Plasmaelektrode angrenzend an die Substrathalteoberfläche der Aufnahmeplatte angeordnet oder in diese integriert. Selbstverständlich können auch der Gasverteiler im Ganzen oder die Aufnahmeplatte im Ganzen als Plasmaelektrode wirken, wobei sie dies jedoch nur während eines Reinigungsschrittes tun. In einer besonderen Ausführungsform ist die Plasmaelektrode ein von dem Gasverteiler und der Aufnahmeplatte getrennter, selbständiger Teil der Vorrichtung und ist beweglich angeordnet, so dass sie in den jeweils zugeordneten Prozessraum hinein- oder aus diesem herausbewegt werden kann. Damit kann die Plasmaelektrode nur bei Bedarf, z.B. zur Durchführung eines Reinigungsprozesses in den jeweiligen Prozessraum eingebracht werden, unterliegt jedoch nicht einer Beschichtung während eines Hochtemperatur-CVD-Prozesses.

Vorzugsweise, und insbesondere wenn die Plasmaelektrode fest im Prozessraum angeordnet ist, also nicht in diesen hinein oder aus diesem heraus bewegt werden kann, weist die Plasmaelektrode Durchbrüche auf, durch die die Prozessgase hindurchtreten können. Die Durchbrüche korrespondieren mit Gaskanälen in dem zugeordneten Gasverteiler, durch welche die Prozessgase in den Prozessraum zugeführt werden, in deren Anordnung und Größe, weisen vorzugsweise jedoch größere Ausdehnungen als diese auf. So kann eine Plasmaelektrode auch ein Gitter mit großen Durchbrüchen und relativ schmalen Gitterbereichen zwischen den Durchbrüchen sein.

Die Plasmaelektrode ist mit einer elektrischen Zuleitung verbunden, die geeignet ist, die Plasmaelektrode mit einer Spannung mit einer Frequenz größer Null, vorzugsweise eine Hochfrequenzspannung mit einer Frequenz größer 10 kHz, besonders bevorzugt im Bereich zwischen 3 MHz und 30 MHz, bspw. 13,56 MHz, zu beaufschlagen. Die entsprechenden elektrischen Zuleitungen können ebenfalls in der bereits erwähnten mindestens einen Versorgungseinheit angeordnet sein.

Selbstverständlich können auch zwei Plasmaelektroden in einem Paar von Gasverteiler und Aufnahmeplatte angeordnet sein, wobei die Plasmaelektroden und die zugehörigen elektrischen Leitungen geeignet sind, die Plasmaelektroden zu einem definierten Zeitpunkt jeweils mit unterschiedlichen Potentialen zu beaufschlagen.

Vorzugsweise sind die Gasverteilerfest in der Prozesskammer angeordnet. Die Aufnahmeplatten können beweglich oder ebenfalls fest in der Prozesskammer angeordnet sein derart, dass sie entweder aus der Vorrichtung und der Prozesskammer hinaus- bzw. in diese hineinbewegt werden können oder eben nicht. Sind die Aufnahmeplatten in diesem Sinne beweglich, so können ein oder mehrere Substrate auf den Aufnahmeplatten außerhalb der Prozesskammer angeordnet und mit diesen in die Prozesskammer und die Vorrichtung ein- bzw. ausgebracht werden. Darüber hinaus sind derartig bewegliche Aufnahmeplatten gut einer Reinigung außerhalb der Prozesskammer zugänglich. Sollen nacheinander Substrate mit verschiedenen Größen oder Umfangsgeometrien beschichtet werden, so können an die jeweilige Größe oder Umfangsgeometrie der Substrate angepasste Aufnahmeplatten ausgewählt und in die Vorrichtung eingebracht werden.

In einer anderen Ausführungsform sind auch die Aufnahmeplatten fest in der Prozesskammer angeordnet. In dieser Ausführungsform werden das oder die Substrate mit aus dem Stand der Technik bekannten Hilfsmitteln in der Hochtemperatur-CVD-Vorrichtung auf den Aufnahmeplatten angeordnet oder von diesen entfernt. Dabei können das oder die Substrate direkt auf der Aufnahmeplatte abgelegt werden oder ein Substrathalter, auf dem das oder die Substrate angeordnet sind, wird auf der Aufnahmeplatte abgelegt.

"Fest angeordnet" bedeutet in diesem Sinne, dass die Aufnahmeplatten nicht aus der Vorrichtung und der Prozesskammer hinausbewegt werden können. Dies gilt auch für die fest angeordneten Gasverteiler. Selbstverständlich können jedoch sowohl die fest angeordneten Gasverteiler als auch die fest angeordneten Aufnahmeplatten aus ihrer Anordnung gelöst, das heißt abmontiert, und aus der Prozesskammer entfernt werden, um sie bspw. zu reinigen oder durch andere Gasverteiler bzw. Aufnahmeplatten zu ersetzen. Jedoch ist es bei fest angeordneten Aufnahmeplatten nicht vorgesehen, diese aus der Vorrichtung und der Prozesskammer zu entfernen, um ein oder mehrere Substrate darauf anordnen oder davon entnehmen zu können. Da fest angeordnete Aufnahmeplatten innerhalb der Vorrichtung verbleiben, entfällt ein gegebenenfalls notwendiges Aufheizen oder Abkühlen der Aufnahmeplatten nach dem Ein- bzw. Ausfahren der Aufnahmeplatten in die bzw. aus der Prozesskammer nach dem Anordnen bzw.

Entfernen eines oder mehrerer Substrate von den Aufnahmeplatten. Damit können auch Aufnahmeplatten mit einer großen Wärmekapazität eingesetzt werden. Vorzugsweise ist eine derartige Aufnahmeplatte trotz ihrer "festen Anordnung" derart bewegbar, dass sie innerhalb der Prozesskammer so ausgerichtet werden kann, dass die zu beschichtende Oberfläche eines auf der Aufnahmeplatte angeordneten Substrats in Bezug auf die Gasaustrittsoberfläche des zugeordneten Gasverteilers parallel angeordnet ist. In einer andern Ausführungsform können die Aufnahmeplatten jedoch auch in dem Sinne unbeweglich sein, dass die zu beschichtende Oberfläche eines auf der Aufnahmeplatte angeordneten Substrats in Bezug auf die Gasaustrittsoberfläche des zugeordneten Gasverteilers nicht aktiv durch eine Bewegung der Aufnahmeplatte ausgerichtet werden kann.

In einer Ausführungsform der Hochtemperatur-CVD-Vorrichtung, bei der sich die Linie, entlang der die Paare angeordnet sind, in vertikaler Richtung erstreckt, und in jedem Paar der Gasverteiler oberhalb der zum selben Prozessraum gehörenden Aufnahmeplatte und die Gasverteiler ortsfest in einer Prozesskammer angeordnet sind, weist die Vorrichtung weiterhin vorzugsweise Abstandshalter zwischen jeweils einem Gasverteiler und einer dazu benachbarten, jedoch nicht zum selben Paar gehörenden und nicht an denselben Prozessraum angrenzenden Aufnahmeplatte auf. Dabei können die Aufnahmeplatten, wie oben beschrieben, entweder fest oder beweglich in der Vorrichtung angeordnet sein. In dieser Ausführungsform ist nur eine Halterung der Gasverteiler innerhalb der Prozesskammer notwendig, während die Aufnahmeplatten durch den jeweils darunterliegenden Gasverteiler über die Abstandshalter gehalten werden. Damit kann eine Halterung der Aufnahmeplatten innerhalb derProzesskammer eingespart werden, während gleichzeitig eine Ausdehnung der Aufnahmeplatten aufgrund eines Aufheizens oder Abkühlens der Aufnahmeplatte auch in vertikaler Richtung möglich ist. Die Abstandshalter können fest mit dem jeweiligen Gasverteiler oder mit der jeweiligen Aufnahmeplatte verbunden sein, wobei, ähnlich wie oben beschrieben, die Abstandshalter abmontiert und bspw. gegen andere Abstandshalter mit einer anderen vertikalen Ausdehnung ausgetauscht werden können. Damit kann auch ein Abstand zwischen dem Gasverteiler und der Aufnahmeplatte eines Paares verändert und an einen bestimmten CVD-Prozess oder eine bestimmte Dicke eines zu beschichtenden Substrates oder eines Substratträgers, auf dem das oder die Substrate gehalten werden, angepasst werden.

In einer Ausführungsform der erfindungsgemäßen Vorrichtung sind ein Gasverteiler und eine Aufnahmeplatte, die zueinander benachbart angeordnet sind, jedoch nicht zum selben Paar gehören und nicht an denselben Prozessraum angrenzen, in einer gemeinsamen Anordnung ausgebildet. Das heißt, dass der Gasverteiler und die Aufnahmeplatte nach außen hin "in einem Stück" ausgebildet sind und nur gemeinsam bewegt werden können. Mit anderen Worten: Der Gasverteiler und die Aufnahmeplatte sind physisch fest miteinander verbunden, wobei die Verbindung lösbar oder unlösbar ausgebildet sein kann. Mit einer solchen Ausführungsform kann die Höhe der gesamten Hochtemperatur-CVD-Vorrichtung reduziert oder bei gleichbleibender Höhe eine größere Anzahl von Paaren von Gasverteiler und Aufnahmeplatte in der Hochtemperatur-CVD-Vorrichtung angeordnet werden. Die erste Variante ermöglicht eine Verbesserung der Homogenität der Schichtabscheidung über die gesamte Höhe der Vorrichtung und eine Verringerung des Aufwands zur Einstellung entsprechender Behandlungsumgebungen in der Prozesskammer, während die zweite Variante eine Erhöhung der Anzahl gleichzeitig beschichtbarer Substrate ermöglicht. Die Höhe der Hochtemperatur-CVD-Vorrichtung wird entlang der Linie, entlang der die Paare von Gasverteiler und Aufnahmeplatte angeordnet sind, gemessen.

In einer weiteren Ausführungsform ist zwischen einem Gasverteiler und einer Aufnahmeplatte, die zueinander benachbart angeordnet sind, jedoch nicht zum selben Paar gehören und nicht an denselben Prozessraum angrenzen, eine Einrichtung zur Wärmeisolation angeordnet. Die Einrichtung zur Wärmeisolation reduziert oder verhindert den Wärmefluss zwischen Gasverteiler und Aufnahmeplatte. Üblicherweise wird die Aufnahmeplatte auf einer ersten Temperatur und der Gasverteiler auf einer zweiten Temperatur gehalten, wobei die erste Temperatur höher als die zweite Temperatur ist. Die erste Temperatur entspricht der gewünschten Temperatur des Substrats während der Beschichtung, z.B. 600°C bis 1100°C, und wird bspw. durch eine Heizeinrichtung eingestellt. Die zweite Temperatur liegt bspw. zwischen 50°C und 100°C, was z.B. durch interne Kühlung des Gasverteilers mit einem Kühlfluid erreicht werden kann. Die Einrichtung zur Wärmeisolation kann z.B. aus einem oder mehreren Wärmeschutzblechen oder einer wärmeisolierenden Beschichtung entsprechender Oberflächen des Gasverteilers und/oder der Aufnahmeplatte bestehen. Sind ein Gasverteiler und eine Aufnahmeplatte, die zueinander benachbart angeordnet sind, jedoch nicht zum selben Paar gehören und nicht an denselben Prozessraum angrenzen, in einer gemeinsamen Anordnung ausgebildet, wie dies oben beschrieben wurde, so ist die Einrichtung zur Wärmeisolation zumindest teilweise in dieser Anordnung integriert und kann bspw. durch Schichten entsprechender wärmeisolierender Materialien innerhalb der Anordnung realisiert sein.

In einer Ausführungsform bilden alle hintereinander entlang einer Linie angeordneten Paare eine Einheit und die Vorrichtung enthält mehrere solche Einheiten. Dabei sind die einzelnen Einheiten lateral nebeneinander und/oder vertikal übereinander derart angeordnet, dass die Linien aller Einheiten parallel zueinander verlaufen. Beispielsweise können bis zu zehn Einheiten in einer Vorrichtung enthalten sein. Verlaufen die Linien, entlang derer die Paare in den einzelnen Einheiten angeordnet sind, in vertikaler Richtung, so sind die Einheiten vorzugsweise lateral nebeneinander angeordnet. Verlaufen hingegen die Linien, entlang derer die Paare in den einzelnen Einheiten angeordnet sind, in horizontaler Richtung, so können die Einheiten lateral nebeneinander und/oder vertikal übereinander angeordnet sein. Damit sind für Prozessdauern von bspw. 6 min Substratdurchsätze durch die Vorrichtung von größer als 3000 Substraten pro Stunde erreichbar.

Die erfindungsgemäße Vorrichtung ist vorzugsweise Bestandteil einer Inline-Anlage, die durch einen unidirektionalen Durchlauf der in der Anlage zu behandelnden Substrate von einer Beladekammer zu einer Entladekammer gekennzeichnet ist, wobei die Substrate in mindestens einer Prozesskammer in mindestens der erfindungsgemäßen Vorrichtung behandelt werden. In der erfindungsgemäßen Vorrichtung werden die Substrate beschichtet, während sie in anderen Vorrichtungen, die Bestandteil der Anlage sind, auch andersartig behandelt werden können, z.B. gereinigt, dotiert, getempert oder strukturiert. Innerhalb der Anlage können die Substrate während der Behandlung in einer der Vorrichtungen stationär oder bewegt angeordnet sein. Zwischen den einzelnen Behandlungsvorrichtungen und/oder den Kammern der Anlage, welche die Beladekammer, die mindestens eine Prozesskammer und die Entladekammer umfasst, werden die Substrate mit Hilfe eines gemeinsamen Transportsystems bewegt. Bei geeigneter Wahl des Transportsystems und einer entsprechenden Ausgestaltung der Behandlungsvorrichtungen, z.B. der Anordnung mehrerer Einheiten von hintereinander entlang einer Linie angeordneten Paaren aus Gasverteiler und Aufnahmeplatte in der erfindungsgemäßen Vorrichtung wie oben beschrieben, können hohe Substratdurchsätze von größer als 3000 Substraten pro Stunde erreicht werden. Zwischen den einzelnen Kammern der Anlage sind vorzugsweise Schleusen angeordnet, welche geeignet sind, die Kammern gasdicht voneinander zu trennen, so dass die in den Kammern während der entsprechenden Behandlungsvorgänge vorliegenden Atmosphären sich nicht gegenseitig beeinflussen. Besonders bevorzugt befinden sich die Substrate während des Transports von einer Kammer zur nächsten immer im Vakuum oder in einer inerten Schutzatmosphäre. Beim Transport im Vakuum entfallen Belüftungs- und Abpumpprozesse innerhalb der einzelnen Prozesskammern und eine Beeinflussung der Substrate oder der darauf befindlichen Schichten durch Bestandteile einer Normalumgebung (Luft) wird vermieden. Der letzte Effekt wird auch bei einem Transport in einer inerten Schutzatmosphäre, z.B. Stickstoff, erreicht. Darüber hinaus wird die Querkontamination zwischen einzelnen Behandlungsvorrichtungen reduziert.

Das Verfahren zum Betreiben einer erfindungsgemäßen Hochtemperatur-CVD-Vorrichtung, welche eine Vielzahl von Plasmaelektroden enthält, wie dies oben beschrieben wurde, umfasst das Ausführen einer Vielzahl von Hochtemperatur-CVD-Prozessen zum Abscheiden einer oder mehrere Schichten auf Substraten, das Ausführen eines Reinigungsprozesses und das Ausführen eines Konditionierungsprozesses.

Jeder der Hochtemperatur-CVD-Prozesse umfasst das Auflegen von zu beschichtenden Substraten auf die Aufnahmeplatten der Vorrichtung, einen Beschichtungsvorgang, bei dem Prozessgase, die zur Abscheidung einer Schicht geeignet sind, in die Prozessräume zugeführt und Prozessgase und flüchtige Reaktionsprodukte aus den Prozessräumen abgeführt werden, sowie das Entfernen der Substrate von den Aufnahmeplatten, wobei die Aufnahmeplatten mindestens während des Beschichtungsvorgangs auf einer ersten Temperatur zwischen 600°C und 1100°C gehalten werden. Während eines Beschichtungsvorgangs wird in jedem Prozessraum ein erster Druck eingestellt, der vorzugsweise im Bereich von 5 kPa (50 mbar) bis 25 kPa (250 mbar) liegt. Die Plasmaelektroden werden während des Beschichtungsvorgangs auf demselben Potential wie alle anderen Bestandteile der Vorrichtung gehalten und liegen vorzugsweise auf Masse. Während der Vielzahl von Beschichtungsvorgängen entstehen parasitäre Schichten zumindest auf den Aufnahmeplatten und den Gasverteilern der Vorrichtung, gegebenenfalls bilden sich derartige parasitäre Schichten und/oder Partikel jedoch auch auf anderen Bestandteilen der Vorrichtung oder der Prozesskammer. Die Anzahl der Hochtemperatur-CVD-Prozesse, die vor einem notwendigen Ausführen eines Reinigungsprozesses ausgeführt werden können, hängt von der Dicke und Beschaffenheit der bei einem Beschichtungsvorgang erzeugten Schicht ab.

Der Reinigungsprozess wird nach der Vielzahl von Hochtemperatur-CVD-Prozessen ausgeführt, wenn eine definierte Dicke der parasitären Schichten, bspw. im Bereich zwischen 30 µm und 300 µm, erreicht ist. Während des Reinigungsprozesses wird ein zweiter Druck, der kleiner als der erste Druck ist und vorzugsweise im Bereich von 10 Pa (0,1 mbar) bis 1 kPa (10 mbar) liegt, in jedem Prozessraum eingestellt und die Aufnahmeplatten werden auf einer zweiten Temperatur, die kleiner als die erste Temperatur ist und zwischen 200°C und 600°C liegt, gehalten. Während des Reinigungsschrittes wird ein fluor- und/oder chlorhaltiges Prozessgas den Prozessräumen zugeführt und die Plasmaelektroden mit einem Potential mit einer Frequenz größer Null, vorzugsweise eine hochfrequente Spannung (wie oben beschrieben), beaufschlagt, während die anderen Bestandteile der Vorrichtung auf einem davon verschiedenen Potential, vorzugsweise Masse, gehalten werden. Damit wird in den Prozessräumen jeweils ein Plasma gezündet, welches aufgrund des vorliegenden Prozessgases zu einer vollständigen Beseitigung parasitärer Schichten auf dem Gasverteiler und der Aufnahmeplatte und zu einer mindestens teilweisen Beseitigung von Partikeln und parasitären Schichten auf anderen Bestandteilen der Vorrichtung und der Prozesskammer infolge eines Ätzprozesses führt. Während des Reinigungsprozesses befindet sich vorzugsweise keinerlei Substrat auf der Aufnahmeplatte. Durch die Plasmaunterstützung des Ätzprozesses können höhere Ätzraten bei gleichzeitig niedrigerer Belastung der Bestandteile der Vorrichtung aufgrund niedrigerer Temperaturen und kürzerer Einwirkzeit des ätzenden Prozessgases als bei Ätzprozessen ohne Plasmaunterstützung erreicht werden.

Der Konditionierungsprozess, der nach dem Reinigungsprozess und vor einer weiteren Vielzahl von Hochtemperatur-CVD-Prozessen ausgeführt wird, entspricht einem solchen Hochtemperatur-CVD-Prozess hinsichtlich der Prozessgase, des Drucks und der Temperatur. Jedoch werden statt der zu beschichtenden Substrate entweder gar keine Substrate oder Konditionierungssubstrate, auch Dummy-Substrate genannt, welche anschließend nicht zu einem fertigen Produkt weiterverarbeitet werden, auf die Aufnahmeplatten aufgelegt und von diesen entfernt. Der Konditionierungsprozess dient der Herstellung nahezu gleicher Randbedingungen für alle Hochtemperatur-CVD-Prozesse der Vielzahl von Hochtemperatur-CVD-Prozessen, die anschließend an den Konditionierungsprozess ausgeführt werden.

Nachfolgend wird die Erfindung anhand der Figuren näher erläutert. Dabei sind die Abmessungen der einzelnen Elemente sowie deren Relation zueinander nicht maßstäblich, sondern nur schematisch widergegeben. Gleiche Bezugszeichen bezeichnen entsprechende gleichartige Bauteile. Es zeigen:
- Fig. 1: einen schematischen Querschnitt durch eine Prozesskammer mit einer ersten Ausführungsform der erfindungsgemäßen Hochtemperatur-CVD-Vorrichtung,
- Fig. 2: einen schematischen Querschnitt durch ein Paar aus einem Gasverteiler und einer Aufnahmeplatte,
- Fig. 3: einen schematischen Querschnitt durch eine Anordnung aus einem Gasverteiler und einer Aufnahmeplatte,
- Fig. 4A: eine schematische Darstellung eines zweistufigen Verteilers innerhalb einer Versorgungseinheit,
- Fig. 4B: eine schematische Darstellung eines binären Verteilers innerhalb einer Versorgungseinheit,
- Fig. 5: einen schematischen Querschnitt durch eine Prozesskammer mit einer zweiten Ausführungsform der erfindungsgemäßen Vorrichtung,
- Fig. 6: einen schematischen Querschnitt durch einen Teil einer dritten Ausführungsform der erfindungsgemäßen Vorrichtung, wobei die Aufnahmeplatten jeweils über Abstandshalter durch die Gasverteiler gehalten werden,
- Fig. 7: einen schematischen Querschnitt durch eine Prozesskammer mit einer vierten Ausführungsform der erfindungsgemäßen Vorrichtung, und
- Fig. 8: ein Ausführungsbeispiel eines erfindungsgemäßen Verfahrens zum Betreiben einer Ausführungsform der erfindungsgemäßen Vorrichtung, welche Plasmaelektroden enthält.

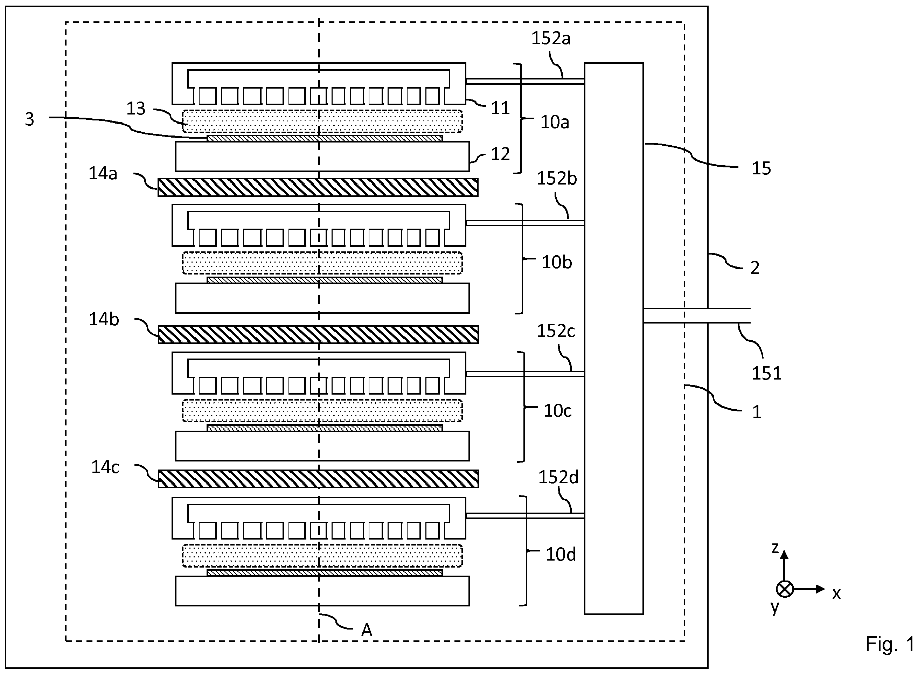

**Figur 1** zeigt einen schematischen Querschnitt durch eine erfindungsgemäße Vorrichtung zur chemischen Gasphasenabscheidung bei hohen Temperaturen in einer ersten Ausführungsform 1. Die Vorrichtung 1 ist in einer Prozesskammer 2 angeordnet, die definierte Umgebungsbedingungen, bspw. einen definierten Druck und eine definierte Gaszusammensetzung, für die Vorrichtung 1 gewährleistet und bereitstellt. Dafür ggf. notwendige Einrichtungen, wie Gaszuführungen oder Gasabsaugungen sind Stand der Technikund hier nicht dargestellt. Die Vorrichtung 1 enthält mehrere Paare 10a bis 10d, die jeweils aus einem Gasverteiler 11 und einer Aufnahmeplatte 12 bestehen. Als Gasverteiler und Aufnahmeplatten können die aus dem Stand der Technik bekannten Gasverteiler und Aufnahmeplatten oder jeder bzw. jede andere, an die Aufgaben des Gasverteilers bzw. der Aufnahmeplatte angepassten Gasverteiler und Aufnahmeplatten genutzt werden. Der Gasverteiler 11 und die Aufnahmeplatte 12 eines bestimmten Paares 10a bis 10d liegen sich gegenüber und begrenzen jeweils einen Prozessraum 13, der dem bestimmten Paar 10a bis 10d zugeordnet ist. Auf der Aufnahmeplatte 12 jedes Paares 10a bis 10d ist während der Durchführung eines Hochtemperatur-CVD-Prozesses ein Substrat 3 angeordnet. Das Substrat 3 kann als solches oder auf einem Substratträger angeordnet auf der Aufnahmeplatte 12 angeordnet werden. Der Gasverteiler 11, die Aufnahmeplatte 12, der Prozessraum 13 und das Substrat 3 sind der besseren Übersichtlichkeit halber nur für das Paar 10a bezeichnet, liegen aber in gleicher Weise bei allen Paaren 10a bis 10d vor. Die Aufnahmeplatte 12 besteht vorzugsweise aus Keramik oder Quarzglas, während der Gasverteiler 11 vorzugsweise aus Metall, bspw. Edelstahl, besteht. Ein Substratträger, auf dem das Substrat gegebenenfalls gehaltert und mit diesem auf der Aufnahmeplatte angeordnet ist, besteht vorzugsweise aus Quarzglas oder Graphit. Vorzugsweise sind die Gasverteiler 11 aller Paare 10a bis 10d und alle Aufnahmeplatten 12 aller Paare 10a bis 10d gleichartig zueinander ausgestaltet, insbesondere bezüglich ihrer Abmessungen und äußeren Form.

Alle Paare 10a bis 10d der Vorrichtung 1 sind hintereinander entlang einer geraden Linie A angeordnet, wobei die Linie A in jedem Paar 10a bis 10d einer Verbindungslinie zwischen dem Gasverteiler 11 und der Aufnahmeplatte 12 entspricht. Dabei sind die Gasverteiler 11 und die Aufnahmeplatten 12 jeweils alternierend entlang der Linie A in der Vorrichtung 1 angeordnet. Die Linie A erstreckt sich dabei entlang einer ersten Richtung (z-Richtung) eines kartesischen Koordinatensystems. Die erste Richtung kann beliebig im Raum angeordnet sein, erstreckt sich jedoch vorzugsweise vertikal oder horizontal. Erstreckt sich die erste Richtung vertikal, so ist der Gasverteiler 11 jeweils oberhalb der Aufnahmeplatte 12 des jeweiligen Paares 10a bis 10d angeordnet. Damit wird das Substrat 3 bedingt durch die Schwerkraft auf der Aufnahmeplatte gehalten.

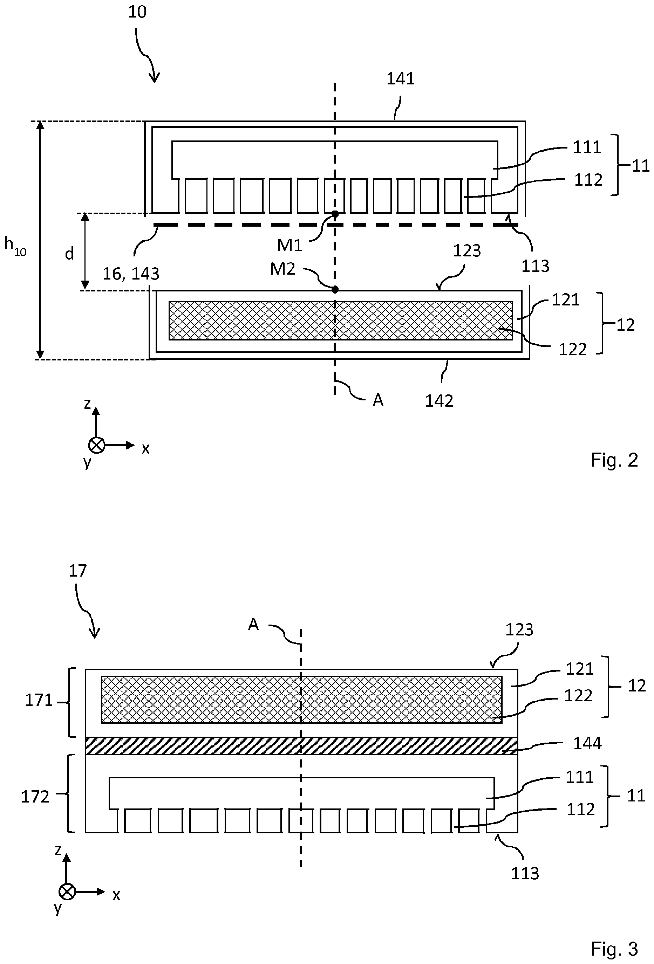

Zwischen den einzelnen Paaren 10a bis 10d sind Einrichtungen 14a bis 14c zur Wärmeisolation angeordnet, die hier nur schematisch dargestellt sind und mit Bezug auf die Figuren 2 und 3 näher erläutert werden. Die Einrichtungen 14a bis 14c zur Wärmeisolation dienen der Reduzierung oder Verhinderung eines Wärmeflusses zwischen einer Aufnahmeplatte 12 und einem Gasverteiler 11, die entlang der Linie A benachbart angeordnet sind, jedoch nicht zum selben Paar 10a bis 10d gehören und damit nicht an denselben Prozessraum 13 angrenzen. Insbesondere soll der Gasverteiler 11 auf einer Temperatur im Bereich zwischen 40°C und 100°C, bevorzugt kleiner als 75°C gehalten werden, damit die durch den Gasverteiler 11 dem Prozessraum 13 zugeführten Prozessgase nicht bereits im Gasverteiler miteinander oder mit Bestandteilen des Gasverteilers reagieren. Für ein Kühlmedium zur Kühlung des Gasverteilers liegen die Temperaturunterschiede zwischen einem dem Gasverteiler zugeführten Kühlmedium und einem aus dem Gasverteiler abgeführten Kühlmedium vorzugsweise zwischen 1 K und 25 K. Demgegenüber wird die Aufnahmeplatte 12 auf eine Temperatur zwischen 600°C und 1100°C, bevorzugt zwischen 700°C und 1000°C, bspw. auf 850°C, aufgeheizt. Um diese Temperaturunterschiede mit einem verträglichen Energieaufwand zu gewährleisten, d.h. einen möglichst geringen Aufwand zur Kühlung des Gasverteilers 11 und zum Heizen der Aufnahmeplatte 12 sicherzustellen, ist eine gute Wärmeisolation notwendig. Darüber hinaus soll durch die Einrichtungen 14a bis 14c zur Wärmeisolation gewährleistet werden, dass die Bestandteile der Hochtemperatur-CVD-Vorrichtung 1 oder andere Bestandteile der Prozesskammer 2 nicht verdampfen und dadurch die zu erzeugenden Schichten auf den Substraten verunreinigen, was bei Vorliegen eines Vakuums im Bereich von 10 Pa (0,1 mbar) bis 50 kPa (500 mbar) und den erwähnten hohen Temperaturen in der Prozesskammer aufgrund der Dampfdrücke der verwendeten Materialien nicht zu vernachlässigen ist.

Zur Bereitstellung notwendiger Medien weist die Vorrichtung 1 mindestens eine Versorgungseinheit 15 auf, die bspw. Prozessgase von außerhalb der Prozesskammer 2 den Gasverteilern 11 zur Verfügung stellt, wie dies beispielhaft in Fig. 1 dargestellt ist. Die Versorgungseinheit 15 erstreckt sich dabei parallel zur Linie A an einer Seite der Prozessräume 13 der Paare 10a bis 10d und kann alle Paare 10a bis 10d mit den notwendigen Medien versorgen, wie dies in Fig. 1 dargestellt ist, oder auch nur einige der Paare 10a bis 10d der Vorrichtung 1. Dazu weist die Versorgungseinheit 15 pro Medium eine Zuführungsleitung 151 und mehrere Auslassleitungen 152a bis 152d auf, wobei die Anzahl der Auslassleitungen pro Medium der Anzahl der von der Versorgungseinheit 15 versorgten Paare 10a bis 10d entspricht.

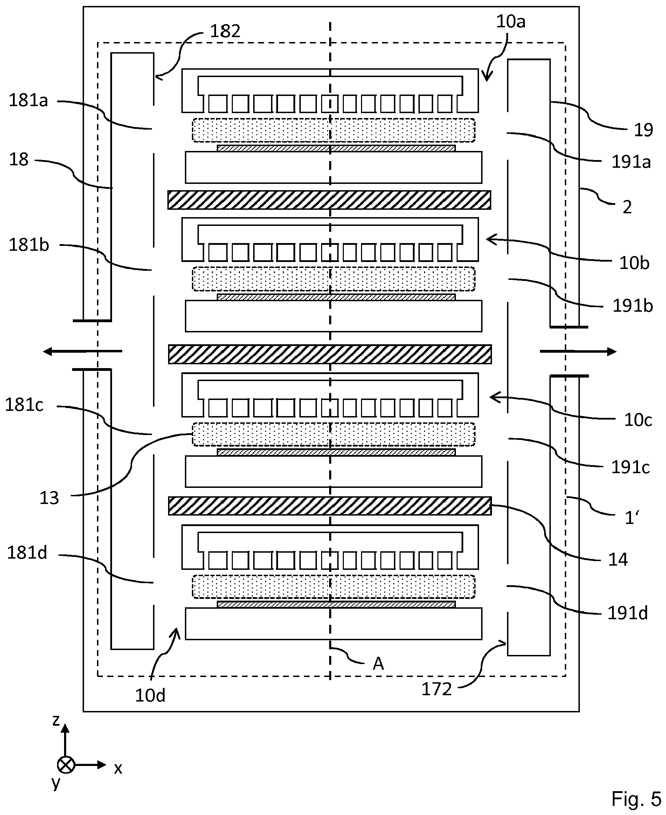

Die Abführung von Prozessgasen und flüchtigen Reaktionsprodukten aus dem Prozessraum 13 kann über eine in dem Gasverteiler 11 integrierte Gasabsaugung realisiert werden, wie sie aus dem Stand der Technik bekannt sind, oder über eine separate Gasabsaugung, wie sie später mit Bezug auf Fig. 5 erläutert wird.

In **Figur 2** sind der Gasverteiler 11 und die Aufnahmeplatte 12 eines Paares 10 sowie Einrichtungen zur Wärmeisolation detaillierter in einem schematischen Querschnitt dargestellt. Der Gasverteiler 11 weist einen Gasvorratsraum 111 und mehrere Gaskanäle 112 auf, wobei die Gaskanäle 112 den Gasvorratsraum 111 mit einer Gasaustrittsoberfläche 113 des Gasverteilers 11 verbinden und in der Gasaustrittsoberfläche 113 Öffnungen bilden, aus denen ein Gas aus dem Gasvorratsraum 111 in einen Prozessraum, wie mit Bezug auf Fig. 1 beschrieben, eingespeist werden kann. Unter dem Begriff "Gas" werden auch Gasgemische verstanden, die aus mehreren Gasen zusammengesetzt sind. Konkrete Ausgestaltungen des Gasverteilers 11 sind aus dem Stand der Technik bekannt. Beispielsweise können auch mehrere Gasvorratsräume ausgebildet sein, aus denen unterschiedliche Gase in den Prozessraum eingeleitet werden können. Darüber hinaus kann der Gasverteiler 11 Kühleinrichtungen enthalten, was ebenfalls aus dem Stand der Technik bekannt ist.

Die Aufnahmeplatte 12 enthält einen Grundkörper 121 und einen Heizer 122, der zur Einstellung einer definierten Temperatur der Aufnahmeplatte 12 im Ganzen oder zumindest einer Substrathalteoberfläche 123 der Aufnahmeplatte 12 dient. Der Heizer 122 ist aus dem Stand der Technik bekannt und kann beispielsweise ein elektrisches Heizelement oder ein fluidbasiertes Heizsystem sein und kann beliebig im Grundkörper 121 der Aufnahmeplatte 122 angeordnet sein. Beispielsweise kann der Heizer 122 an die Substrathalteoberfläche 123 angrenzen oder von dieser beabstandet sein und kann den gesamten Grundkörper 121 teilweise oder im Ganzen ausfüllen. Die Substrathalteoberfläche 123 ist die Oberfläche der Aufnahmeplatte 12, auf oder an der ein Substrat angeordnet ist und während des Hochtemperatur-CVD-Prozesses gehalten wird. Dazu kann die Aufnahmeplatte 12 weitere Halteeinrichtungen, z.B. Klemmen, Pins oder Aussparungen, aufweisen, die jedoch im Sinne der Übersichtlichkeit der Darstellung hier nicht gezeigt sind.

Einrichtungen zur Gaszuführung zum Gasvorratsraum 11 oder zur Zuführung von Medien, z.B. Fluide oder elektrischer Strom, die zur Kühlung des Gasverteilers 11 oder zum Heizen der Aufnahmeplatte 12 notwendig sind, sind in den Figuren nicht dargestellt. Sie können sich bspw. in einer Ebene, die in y-Richtung vor oder hinter der dargestellten Querschnittsebene befinden, angeordnet sein.

Die Gasaustrittsoberfläche 113 und die Substrathalteoberfläche 123 erstecken sich jeweils in einer Ebene, die von der Linie A geschnitten wird. Dabei ist unter dem Begriff "Ebene" nicht eine vollkommen ebene Fläche im mathematischen Sinne zu verstehen, sondern eine Lageebene. Das heißt, die Gasaustrittsoberfläche 113 und die Substrathalteoberfläche 123 müssen nicht vollkommen eben sein, sondern können Vorsprünge oder Vertiefungen aufweisen und/oder können auch gekrümmt sein. Vorzugsweise erstrecken sich die Gasaustrittsoberfläche 113 und die Substrathalteoberfläche 123 in zueinander parallelen Ebenen, so dass der Abstand zwischen der Gasaustrittsoberfläche 113 und der Substrathalteoberfläche 123 überall gleich ist. Weiterhin vorzugsweise erstrecken sich die Gasaustrittsoberfläche 113 und die Substrathalteoberfläche 123 jeweils in einer Ebene, die durch eine zweite und eine dritte Richtung des kartesischen Koordinatensystems, dem die erste Richtung angehört, aufgespannt wird (x-y-Ebene in den Figuren). In diesem Fall verläuft die Linie A senkrecht zu der Gasaustrittsoberfläche 113 und der Substrathalteoberfläche 123. Die Gasaustrittsoberfläche 113 weist einen Mittelpunkt M1 und die Substrathalteoberfläche 123 weist einen Mittelpunkt M2 auf.

Wie bereits mit Bezug auf Fig. 1 erwähnt, entspricht die Linie A einer Verbindungslinie zwischen dem Gasverteiler 11 und der Aufnahmeplatte 12 und verbindet dabei vorzugsweise die Mittelpunkte M1 und M2 der Gasaustrittsoberfläche 113 und der Substrathalteoberfläche 123 miteinander.

Typische Abmessungen der Gasaustrittsoberfläche 113 sind eine Länge (bspw. in x-Richtung) im Bereich von 50 mm bis 500 mm und eine Breite (bspw. in y-Richtung) im Bereich von 50 mm bis 500 mm, während die Substrathalteoberfläche 123 typischerweise eine Länge (bspw. in x-Richtung) im Bereich von 100 mm bis 200 mm und eine Breite (bspw. in y-Richtung) im Bereich von 100 mm bis 200 mm aufweist. Der Abstand d zwischen der Gasaustrittsoberfläche 113 und der Substrathalteoberfläche 123 entlang der ersten Richtung (z-Richtung) liegt typischerweise im Bereich von 5 mm bis 20 mm, wobei die Dicke des Substrates bspw. im Bereich von 75 µm bis 200 µm liegt.

Zur Abschirmung des Gasverteilers 11 von einer heißen Aufnahmeplatte, die entlang der z-Richtung oberhalb des Gasverteilers 11 angeordnet ist und nicht zum selben Paar 10 gehört, ist der Gasverteiler 11 von einem ersten Wärmeschutzblech 141, bspw. aus Edelstahl oder Molybdän, auf den Seiten, die nicht die Gasaustrittsoberfläche 113 bilden, umgeben. Das erste Wärmeschutzblech 141 liegt auf einer Temperatur von bspw. 250°C. Zur Abschirmung der heißen Aufnahmeplatte 12 von einem Gasverteiler, der entlang der z-Richtung unterhalb der Aufnahmeplatte 12 angeordnet ist und nicht zum selben Paar 10 gehört, ist die Aufnahmeplatte 12 von einem zweiten Wärmeschutzblech 142, bspw. aus Keramik, auf den Seiten, die nicht die Substrathalteoberfläche 123 bilden, umgeben. Das zweite Wärmeschutzblech 142 liegt auf einer Temperatur von bspw. 500°C. Damit ist bereits eine gute Wärmeisolation zwischen Gasverteilern und Aufnahmeplatten, die nicht zum selben Paar 10 gehören, erreichbar.

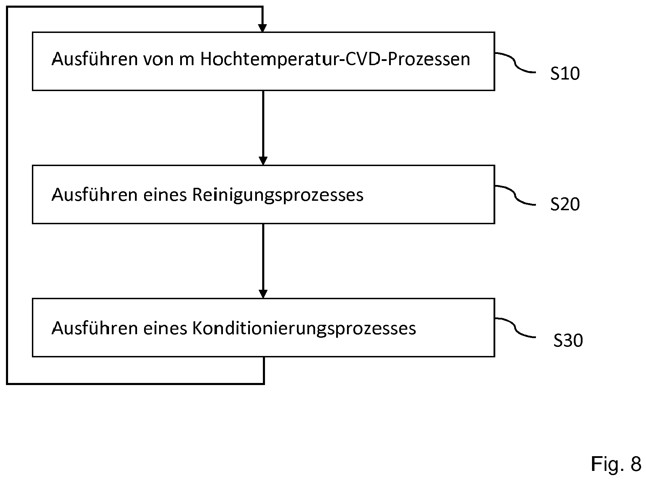

Darüber hinaus kann zwischen dem Gasverteiler 11 und der Aufnahmeplatte 12 ein und desselben Paares 10 eine Gasverteilerabschirmung 143, bspw. aus Keramik oder Quarzglas, angeordnet sein, die die Gasaustrittsoberfläche 113 des Gasverteilers 11 von den Prozessgasen im Prozessraum, welche eine Temperatur im Bereich zwischen 100°C und 1100°C aufweisen, sowie von einer Wärmestrahlung von der Aufnahmeplatte 12 thermisch abschirmt. Die Gasverteilerabschirmung 143 liegt dabei auf einer Temperatur von bspw. 400°C. Dabei weist die Gasverteilerabschirmung 143 Öffnungen auf, die zu den Öffnungen der Gaskanäle 112 in der Gasaustrittsoberfläche 113 korrespondieren, jedoch größere laterale Abmessungen, z.B. größere Durchmesser, aufweisen können. Wenn die Gasverteilerabschirmung 143 aus einem elektrisch leitfähigen Material besteht, kann die Gasverteilerabschirmung 143 auch gleichzeitig eine Plasmaelektrode 16 sein, die in einem Reinigungsprozess zum Erzeugen eines Plasmas genutzt werden kann, wie dies mit Bezug auf Fig. 8 erläutert wird. Selbstverständlich können die Gasverteilerabschirmung 143 und die Plasmaelektrode 16 auch separat voneinander ausgebildet und in der Vorrichtung angeordnet sein.

Die gesamte Höhe h₁₀ eines Paares 10 inclusive der Wärmeschutzbleche 141 und 142 liegt im Bereich von 20 mm bis 100 mm.

Selbstverständlich können anstatt der oder zusätzlich zu den Wärmeschutzblechen 141 und 142 und/oder der Gasverteilerabschirmung 143 auch Beschichtungen auf den entsprechenden Oberflächen des Gasverteilers 11 und/oder der Aufnahmeplatte 12 ausgebildet sein, die die Funktion der Wärmeisolation übernehmen. Das zweite Wärmeschutzblech 142 kann auch durch eine entsprechende wärmereflektierende Schicht innerhalb der Aufnahmeplatte 12 ersetzt oder ergänzt werden.

Auch weitere Einrichtungen zur Wärmeisolation, z.B. zwischen den Aufnahmeplatten 12 und/oder Prozessräumen 13 und anderen Bestandteilen der Vorrichtung, wie z.B. der Versorgungseinheit 15, oder der Prozesskammer 2 können vorhanden und entsprechend der gewünschten Wärmeisolation ausgelegt sein.

**Figur 3** zeigt einen schematischen Querschnitt durch eine Anordnung 17 aus einem Gasverteiler 11 und einer Aufnahmeplatte 12, die ein gemeinsames Gebilde bilden. Dabei sind der Gasverteiler 11 und die Aufnahmeplatte 12 entlang der ersten Richtung (z-Richtung) benachbart zueinander angeordnet, d.h. es befinden sich keine anderen Gasverteiler oder Aufnahmeplatten dazwischen. Gleichzeitig sind der Gasverteiler 11 und die Aufnahmeplatte 12 Bestandteile voneinander verschiedener Paare aus Gasverteiler und Aufnahmeplatte und grenzen nicht an denselben Prozessraum. Damit liegen sich die Substrathalteoberfläche 123 der Aufnahmeplatte 12 und die Gasaustrittsoberfläche 113 des Gasverteilers 13 nicht gegenüber, sondern bilden die beiden flächigen Oberflächen der Anordnung 17, die von der Linie A geschnitten werden. Die Anordnung 17 weist einen ersten Bereich 171 und einen zweiten Bereich 172 auf, wobei die Aufnahmeplatte 12 den ersten Bereich 171 und der Gasverteiler 11 den zweiten Bereich 172 bildet. Zwischen dem ersten Bereich 171 und dem zweiten Bereich 172 ist in der dargestellten Ausführungsform eine Wärmeisolationsschicht 144 angeordnet, welche die Funktion der Wärmeisolation erfüllt. Eine solche Wärmeisolationsschicht 144 besteht bspw. aus Edelstahl-, Wolfram- oder Molybdänblech oder auch Quarzglas oder Keramik und weist eine Dicke (in z-Richtung) im Bereich von 0,1 mm bis 3 mm auf. Darüber hinaus kann die Anordnung 17 noch Verbindungsschichten zwischen dem ersten Bereich 171 und dem zweiten Bereich 172 bzw. zwischen dem ersten Bereich 171 und der Wärmeisolationsschicht 144 und/oder der Wärmeisolationsschicht 144 und dem zweiten Bereich 172 aufweisen. Diese Verbindungsschichten dienen der festen physischen Verbindung der genannten Schichten und können bspw. aus Metall oder Keramik bestehen. Die Verbindungsschichten können jedoch auch entfallen, wenn die Aufnahmeplatte 12, der Gasverteiler 11 und ggf. die Wärmeschutzschicht 144 direkt miteinander verbindbar sind, z.B. durch Schweißen. Ebenfalls möglich ist die Verbindung des ersten Bereiches 171 und des zweiten Bereiches 172 durch eine von außen einwirkende Verbindungseinrichtung, z.B. eine Klemmvorrichtung oder eine geschraubte Verbindungslasche.

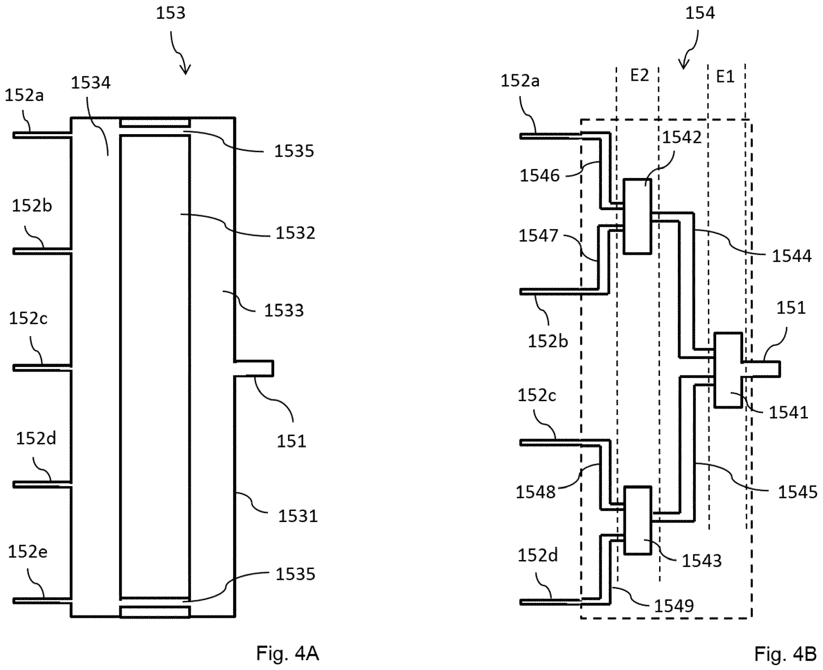

In den **Figuren 4A und 4B** sind zwei Ausführungsformen eines Verteilers zum Verteilen eines Mediums in einer Versorgungseinheit dargestellt. Dabei zeigt Fig. 4A einen zweistufigen Verteiler 153, während Fig. 4B einen binären Verteiler 154 zeigt. Beide Verteiler können zur Zu- oder Abführung von Prozessgasen und/oder von Heiz oder Kühlmedien eingesetzt werden, während das Prinzip des binären Verteilers 154 auch bei der Zuführung von elektrischen Spannungen oder Strömen umgesetzt werden kann. Beispielhaft soll die Funktionsweise der Verteiler an Hand der Zuführung eines Prozessgases erläutert werden.

Der zweistufige Verteiler 153 in Fig. 4A umfasst einen Verteilraum 1531 sowie die Zuführungsleitung 151 und die Auslassleitungen 152a bis 152e, welche bereits mit Bezug auf die Versorgungseinheit 15 in Fig. 1 erwähnt wurden. In Fig. 4A sind beispielhaft fünf Auslassleitungen 152a bis 152e dargestellt, wobei jede Auslassleitung 152a bis 152e jeweils ein Paar von Gasverteiler und Aufnahmeplatte mit einem Medium versorgt. Der Verteilraum 1531 enthält einen Block 1532 aus einem festen, vorzugsweise gasundurchlässigen, Material, der den Verteilraum 1531 in einen Einlassraum 1533 und einen Auslassraum 1534 unterteilt. Der Einlassraum 1533 ist mit der Zuführungsleitung 151 verbunden, während der Auslassraum 1534 mit den Auslassleitungen 152a bis 152e verbunden ist. Der Block 1532 weist Durchlässe 1535 auf, die vorzugsweise am Rand des Blocks 1532 angeordnet und gleichverteilt über die Ausdehnung des Blocks 1532 sind. Die Durchlässe 1535 verbinden den Einlassraum 1533 und den Auslassraum 1534 miteinander und ermöglichen den Durchtritt eines Gases vom Einlassraum 1533 in den Auslassraum 1534. Über die Gestaltung der Abmessungen des Einlassraums 1533 und der Durchlässe 1535 kann eine gleichmäßige Verteilung eines Gases, welches über die Zuführleitung 152 in den Einlassraum 1533 einströmt, und insbesondere nahezu gleich Druckverhältnisse an allen Durchlässen 1535 erreicht werden. Beispielsweise kann der Verteilraum 1531 in einer Ebene, die zwischen der Zuführungsleitung 151 und den Auslassleitungen 152a bis 152e und orthogonal dazu angeordnet ist, eine kreisrunde Form aufweisen, bei der die Durchlässe 1535 jeweils in der Nähe des äußeren Randes des Verteilraums 1531 angeordnet sind. Damit liegen auch im Auslassraum 1534 überall die nahezu gleichen Druckverhältnisse vor, so dass das Gas aus dem Auslassraum 1534 gleichmäßig auf die Auslassleitungen 152a bis 152e verteilt wird.

Der binäre Verteiler 154 in Fig. 4B umfasst drei Teiler 1541 bis 1543, welche mit jeweils einer zuführenden ersten Leitung und zwei wegführenden zweiten Leitungen verbunden sind, und Leitungen 1544 bis 1549. Beim Teiler 1541 ist die erste Leitung die Zuführungsleitung 151 und die beiden zweiten Leitungen sind die Leitungen 1544 und 1545. Jede wegführende zweite Leitung ist wiederum eine erste Leitung für einen nachfolgenden Teiler. Damit ist die Leitung 1544 die erste Leitung für den Teiler 1542 und die Leitung 1545 ist die erste Leitung für den Teiler 1543. Die Leitungen 1546 und 1547 sind die wegführenden zweiten Leitungen des Teilers 1542, während die Leitungen 1548 und 1549 die wegführenden zweiten Leitungen des Teilers 1543 sind. Die Leitungen 1546 bis 1549 gehen jeweils in die Auslassleitungen 152a bis 152d überbzw. entsprechen diesen. Da in jedem Teiler 1541 bis 1543 ein über die entsprechende erste Leitung einströmendes Gas auf zwei wegführende Leitungen aufgeteilt wird, wird diese Art von Verteiler binärer Verteiler genannt. Dabei sind die Teiler jeweils entlang des Strömungsweges des Gases in verschiedenen Ebenen angeordnet. In dem in Fig. 4B dargestellten Beispiel liegen zwei Ebenen E1 und E2 vor, wobei der Teiler 1541 in der Ebene E1 angeordnet ist, während die Teiler 1542 und 1543 zur Ebene E2 gehören. Es sind n Ebenen hintereinander anordenbar, wobei n eine beliebige natürliche Zahl ist. Abhängig von der Anzahl n der Ebenen kann ein über die Zuführungsleitung 151 einströmendes Gas auf 2ⁿ Auslassleitungen verteilt werden. Da im dargestellten Beispiel n = 2 ist, können somit 2² = 4 Auslassleitungen 152a bis 152d mit einem Gas versorgt werden.

In **Figur 5** ist ein schematischer Querschnitt durch die Prozesskammer 2 mit der erfindungsgemäßen Hochtemperatur-CVD-Vorrichtung in einer zweiten Ausführungsform 1' dargestellt. Die Vorrichtung 1' weist neben den Paaren 10a bis 10d aus Gasverteilern und Aufnahmeplatten und den Einrichtungen 14 zur Wärmeisolation, wie sie bereits mit Bezug auf Fig. 1 erläutert wurden, eine erste Gasabsaugeinrichtung 18 und eine zweite Gasabsaugeinrichtung 19 auf. Selbstverständlich können daneben Versorgungseinheiten 15 zum Zuführen oder Abführen weiterer Medien in der Vorrichtung 1' enthalten sein. Die erste Gasabsaugeinrichtung 18 und die zweite Gasabsaugeinrichtung 19 sind auf gegenüberliegenden Seiten der Paare 10a bis 10d angeordnet, wobei die Seiten parallel zur Linie A verlaufen und sich entlang einer Richtung, die in der Ebene der Gasaustrittsoberfläche oder in der Ebene der Substrathalteoberfläche verläuft, gegenüberliegen. Dabei weist die erste Gasabsaugeinrichtung 18 Gasabsaugöffnungen 181a bis 181 d in einer Absaugoberfläche 182 auf, während die zweite Gasabsaugeinrichtung 19 Gasabsaugöffnungen 191 a bis 191 d in einer Absaugoberfläche 192 aufweist. Die Absaugoberflächen 182, 192 sind die den Paaren 10a bis 10d zugewandten Oberflächen der Gasabsaugeinrichtungen 18 bzw. 19.

Die Absaugoberflächen 182 und 192 erstrecken sich vorzugsweise parallel zu den Seitenflächen der Paare 10a bis 10d und sind in ihren Abmessungen und ihrer Formgebung an die Abmessungen der Paare 10a bis 10d und deren äußeren Form angepasst. Weisen bspw. die Seitenflächen der Paare 10a bis 10d eine gekrümmte Form auf, d.h. die Paare 10a bis 10d haben in einer Draufsicht (d.h. auf die x-y-Ebene) eine kreisrunde, ovale oder andere Form ohne gerade Kanten, so sind die Absaugoberflächen 182 und 192 ebenfalls gekrümmt und korrespondieren in einer Draufsicht zu einem Teil der Umfangslinie der Paare 10a bis 10d. Weisen die Paare 10a bis 10d hingegen in der Draufsicht eine eckige Form auf, bspw. eine rechteckige oder sechseckige Form, so sind die Absaugoberflächen 182 und 192 eben ausgestaltet und korrespondieren jeweils mit einer Seite der Umfangslinie der Paare 10a bis 10d in der Draufsicht. Dabei sind die Gasabsaugeinrichtungen 18 und 19 so angeordnet, dass sie ein Einbringen und Entnehmen der Substrate in die bzw. aus der Vorrichtung 1' hinein bzw. heraus nicht behindern. Die erste und die zweite Gasabsaugeinrichtung 18 und 19 sind geeignet, aus allen Prozessräumen 13 Gas abzusaugen. Dazu erstrecken sie sich mit ihrer Absaugoberfläche 182, 192 entlang der ersten Richtung (z-Richtung) über alle Paare 10a bis 10d hinweg, wobei jedem bestimmten Prozessraum 13 eine bestimmte Gasabsaugöffnung 182a bis 182d bzw. 192a bis 192d zugeordnet ist. So sind bspw. die Gasabsaugöffnungen 182a und 192a dem Prozessraum 13 des ersten Paares 10a zugeordnet. Dabei kann eine Gasabsaugöffnung 182a bis 182d und 192a bis 192d auch aus einer Vielzahl von einzelnen kleinen Teilöffnungen bestehen, die in einer bestimmten Anordnung zueinander in der Absaugoberfläche 182 bzw. 192 angeordnet sind. Vorzugsweise kann die Absaugleistung jeder Gasabsaugöffnung 182a bis 182d und 192a bis 192d auf bestimmte Weise ausgelegt sein, bspw. durch die Größe der einzelnen Öffnungen oder Teilöffnungen oder der Anzahl und Anordnung der Teilöffnungen. Die aus den einzelnen Prozessräumen 13 abgesaugten Gase können gemeinsam nach außerhalb der Vorrichtung 1' und ggf. nach außerhalb der Prozesskammer 2 geleitet werden, wie dies in Fig. 5 durch den Pfeil angedeutet ist. Selbstverständlich können auch voneinander getrennte Ausleitungen für einen, einige oder alle Teilbereiche der Gasabsaugeinrichtungen 18 und 19, von denen jeder einer bestimmten Gasabsaugöffnung 182a bis 182d und 192a bis 192d zugeordnet ist, vorgesehen sein.

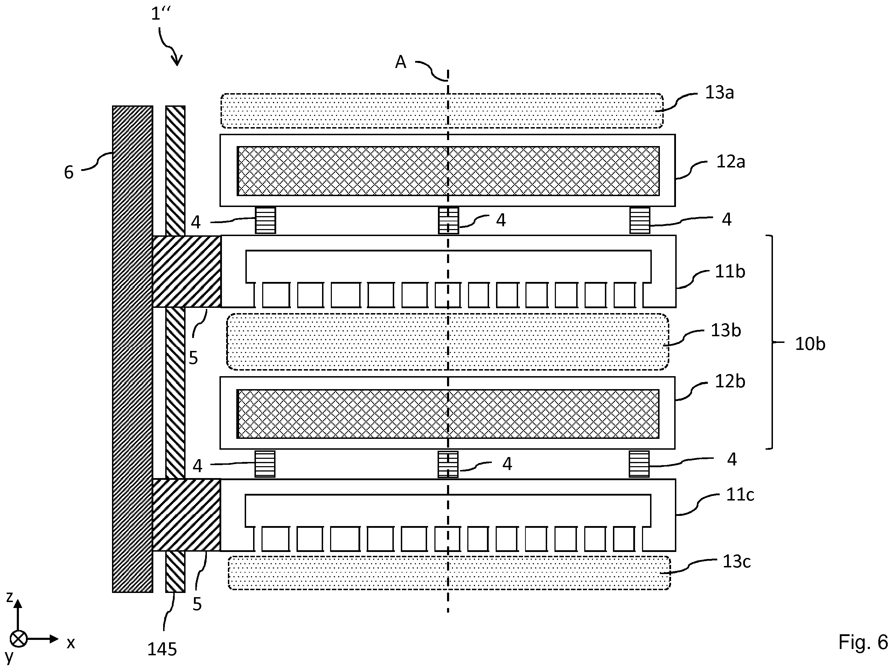

In **Figur 6** ist ein schematischer Querschnitt durch einen Teil einer dritten Ausführungsform 1" der erfindungsgemäßen Hochtemperatur-CVD-Vorrichtung dargestellt. Gezeigt ist ein Paar 10b aus Gasverteiler 11b und Aufnahmeplatte 12b vollständig, während von einem weiteren Paar aus Gasverteiler und Aufnahmeplatte nur die Aufnahmeplatte 12a und von einem anderen weiteren Paar aus Gasverteiler und Aufnahmeplatte nur der Gasverteiler 11 c dargestellt ist. Zu sehen sind darüber hinaus noch-zumindest teilweise-die Prozessräume 13a bis 13c. Die Linie A erstreckt sich dabei in vertikaler Richtung (z-Achse), während die Gasaustrittsoberflächen der Gasverteiler 11b und 11 c sowie die Substrathalteoberflächen der Aufnahmeplatten 12a und 12b sich horizontal erstrecken. Zwischen einem Gasverteiler und einer darüber angeordneten Aufnahmeplatte sind Abstandshalter 4 angeordnet, wobei beispielhaft jeweils drei Abstandshalter pro Zwischenraum dargestellt sind. Jedoch ist die Anzahl der Abstandshalter nicht auf 3 beschränkt, sondern kann auch 1, 2 oder mehr als 3 betragen. Die Abstandshalter 4 bestehen vorzugsweise aus einem wärmeisolierenden Material, bspw. aus Keramik oder Quarzglas, und weisen vorzugsweise einen kleinen thermischen Ausdehnungskoeffizienten auf. Wie bereits allgemein beschrieben, können die Gasverteiler und Aufnahmeplatten der erfindungsgemäßen Hochtemperatur-CVD-Vorrichtung fest oder beweglich innerhalb einer Prozesskammer angeordnet sein. In der dritten Ausführungsform 1" sind die Gasverteiler fest in der Prozesskammer angeordnet. Dazu sind sie mit Trägern 5 verbunden, welche wiederum von einer Halterung 6 gehalten werden. Die Halterung 6 erstreckt sich dabei vertikal und vorzugsweise entlang aller Paare aus Gasverteiler und Aufnahmeplatte und ist auf einer lateralen Seite der Paare angeordnet. Dabei ermöglicht die Halterung 6 eine innerhalb der Prozesskammer ortsfeste Anordnung der Gasverteiler, insbesondere bezüglich der vertikalen Richtung (zAchse). Da die Gasverteiler gekühlt werden, unterliegen sie selbst auch kaum einer thermischen Ausdehnung. Demgegenüber dehnen sich die Aufnahmeplatten, die aufgeheizt und abgekühlt werden können und deren Temperatur zwischen 100°C und 1100°C, bspw. zwischen 200°C und 1000°C, definiert eingestellt werden kann, entsprechend der vorliegenden Temperatur aus. Um eine Ausdehnung der Aufnahmeplatten in vertikaler Richtung zu ermöglichen, liegen die Aufnahmeplatten auf den Abstandshaltern 4 auf, wobei die Abstandshalter 4 fest mit der Aufnahmeplatte oder fest mit dem Gasverteiler verbunden sein können. Auch eine Anpassung des Abstandes zwischen Substrathalteoberfläche und der zugehörigen Gasaustrittsoberfläche ist möglich, indem Abstandshalter 4 mit einer ersten Höhe, d.h. vertikalen Ausdehnung entlang der z-Achse, gegen Abstandshalter 4 mit einer zweiten Höhe ausgetauscht werden. Dabei muss die Lage der Gasverteiler innerhalb der Prozesskammer nicht verändert werden. Darüber hinaus ist eine Bewegung der Aufnahmeplatten aus der Vorrichtung 1" heraus oder diese hinein besonders einfach realisierbar, da die Abstandshalter 4 einen definierten Abstand zwischen den Gasverteilern und darüber angeordneten Aufnahmeplatten ermöglicht, ohne die Lage der Aufnahmeplatten in der Vorrichtung aufwendig einstellen zu müssen.

Damit eine ortsfeste Anordnung der Gasverteiler innerhalb der Prozesskammer besonders gut realisiert werden kann, ist vorzugsweise eine weitere Wärmeschutzanordnung 145 zwischen den Paaren aus Gasverteiler und Aufnahmeplatten und der Halterung 6 angeordnet, so dass die Halterung 6 thermisch von heißen Elementen der Vorrichtung 1" isoliert ist

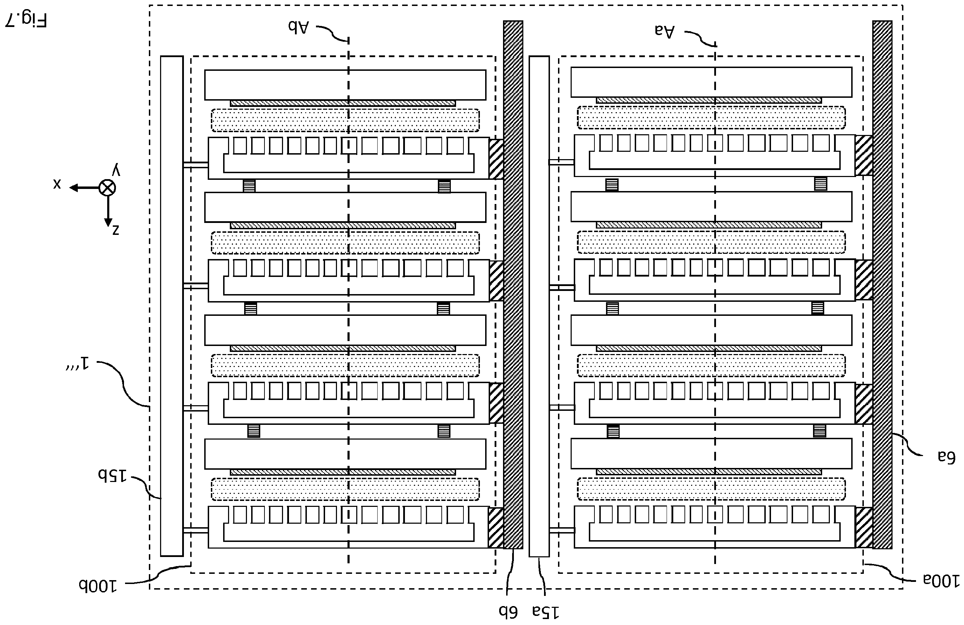

**Figur 7** zeigt einen schematischen Querschnitt durch die erfindungsgemäße Hochtemperatur-CVD-Vorrichtung in einer vierten Ausführungsform 1"'. Die Vorrichtung 1'" weist zwei Einheiten 100a und 100b auf, wobei in jeder Einheit 100a bzw. 100b alle Paare bestehend aus einem Gasverteiler und einer Aufnahmeplatte hintereinander entlang einer Linie Aa bzw. Ab angeordnet sind. Dabei verlaufen die Linien Aa und Ab parallel zueinander und die Einheiten 100a und 100b sind entlang der x-Richtung, die senkrecht zur ersten Richtung (z-Richtung) verläuft, nebeneinander angeordnet. Jedoch können weitere Einheiten auch entlang der y-Richtung neben der Einheit 100a oder 100b oder neben beiden Einheiten 100a und 100b angeordnet sein, solange sie ein Einbringen und Entnehmen der Substrate in die bzw. aus den einzelnen Einheiten der Vorrichtung 1'" hinein bzw. heraus nicht behindern.

Die Vorrichtung 1'" weist in dem in Fig. 7 dargestellten Beispiel darüber hinaus für jede der Einheiten 100a und 100b eine Versorgungseinheit 15a, 15b und eine Halterung 6a, 6b auf, die wie mit Bezug auf die Fig. 1 und 6 erläutert, entlang der Seiten der Einheiten 100a bzw. 100b angeordnet sind.

Die Anzahl der Einheiten aus hintereinander entlang einer Linie angeordneten Paaren aus einem Gasverteiler und einer Aufnahmeplatte ist nicht auf die hier dargestellten zwei Einheiten 100a und 100b begrenzt. Vorzugsweise weist die Vorrichtung 1"' bis zu 10 Einheiten auf. Jedoch können sich auch beide Einheiten 100a und 100b (oder falls vorhanden auch mehrere dieser Einheiten) eine Versorgungseinheit und/oder eine Halterung teilen.

Einige oder alle der genannten Möglichkeiten zur Ausgestaltung der erfindungsgemäßen Vorrichtung zur Hochtemperatur-CVD können auch miteinander kombiniert werden, solange sie sich nicht gegenseitig ausschließen.

**Figur 8** zeigt ein Beispiel für ein erfindungsgemäßes Verfahren zum Betreiben einer erfindungsgemäßen Ausführungsform der Hochtemperatur-CVD-Vorrichtung, welche Plasmaelektroden enthält, wie dies mit Bezug auf die Fig. 2 erläutert wurde. In dem Verfahren werden zunächst eine Anzahl m von Hochtemperatur-CVD-Prozessen ausgeführt (Schritt S10). Die Anzahl m liegt bspw. zwischen 10 und 1000. Jeder dieser Prozesse umfasst das Auflegen von zu beschichtenden Substraten auf die Aufnahmeplatten der Hochtemperatur-CVD-Vorrichtung, das Ausführen eine Hochtemperatur-CVD-Beschichtungsvorgangs und das Entfernen der Substrate von den Aufnahmeplatten. Bei dem Beschichtungsvorgang werden Prozessgase, die zur Abscheidung einer Schicht geeignet sind, z.B. Silan, in die Prozessräume der Hochtemperatur-CVD-Vorrichtung zugeführt und nicht umgesetzte Prozessgase sowie flüchtige Reaktionsprodukte werden aus den Prozessräumen abgeführt. Die Aufnahmeplatten werden mindestens während des Beschichtungsvorgangs auf einer ersten Temperatur gehalten, z.B. auf 850°C. Während des Beschichtungsvorgangs wird ein erster Druck, z.B. von 10 kPa (100 mbar), in den Prozessräumen eingestellt. Die Plasmaelektroden, welche entweder fest in der Vorrichtung installiert sind oder für die Hochtemperatur-CVD-Prozesse aus den Prozessräumen entfernt, z.B. aus den Prozessräumen hinausgeschwenkt, wurden, liegen auf demselben Potential wie alle anderen Bestandteile der Vorrichtung, z.B. auf Masse. Bei dem Beschichtungsvorgang werden Schichten mit einer Rate im Bereich von 10 nm/min bis 100 nm/min abgeschieden, wobei jedoch auch Abscheidungen mit einer hohen Rate größer als 1 µm/min möglich sind.

Nach der Ausführung der m Hochtemperatur-CVD-Prozesse wird ein Reinigungsprozess ausgeführt (S20). Bei diesem werden keine Substrate in die Hochtemperatur-CVD-Vorrichtung eingeführt und abgelegt. Die Temperatur der Aufnahmeplatten wird auf eine zweite Temperatur, z.B. 200°C, und der Druck in den Prozessräumen auf einen zweiten Druck, z.B.50 Pa (0,5 mbar), eingestellt. Die zweite Temperatur ist kleiner als die erste Temperatur und der zweite Druck ist kleiner als der erste Druck. Falls die Plasmaelektroden während der Hochtemperatur-CVD-Prozesse außerhalb der Prozessräume angeordnet waren, so werden sie nunmehr in die Prozessräume eingebracht. Während des Reinigungsprozesses wird ein fluor- und/oder chlorhaltiges Prozessgas, z.B. NF₃, in die Prozessräume zugeführt. An die Plasmaelektroden wird eine hochfrequente Spannung, z.B. 300 V Wechselspannung mit einer Frequenz von 13,56 MHz, angelegt, während die übrigen Bestandteile der Hochtemperatur-CVD-Vorrichtung auf einem anderen Potential liegen, z.B. auf Masse. Durch die zugeführte Spannung wird in den Prozessräumen je ein Plasma gezündet und aufrechterhalten, wodurch ein plasmaunterstützter Ätzprozess ausgeführt wird, welcher die in den m Hochtemperatur-CVD-Prozessen entstandenen parasitären Schichten auf der Aufnahmeplatte und dem Gasverteiler vollständig sowie auf anderen Bestandteilen der Vorrichtung zumindest teilweise entfernt. Solch ein Ätzprozess wird bspw. für 15 min ausgeführt, wobei die Dauer eines solchen Schrittes von der Dicke der parasitären Schichten, deren Zusammensetzung, dem verwendeten Prozessgas während des Reinigungsschrittes und den anderen Randbedingungen des Ätzprozessen wie Druck, Temperatur und über die Plasmaelektroden eingebrachte Leistung abhängt. Nach Beendigung des Ätzprozesses werden die Plasmaelektroden wieder aus den Prozessräumen der Vorrichtung entfernt, falls sie während der Hochtemperatur-CVD-Prozesse in Schritt S10 außerhalb der Prozessräume angeordnet waren.

Nach der Beendigung des Reinigungsprozesses erfolgt ein Konditionierungsprozess (S30). Dieser gleicht einem Hochtemperatur-CVD-Prozess aus Schritt S10, wobei jedoch keine zu beschichtenden Substrate auf die Aufnahmeplatten aufgelegt werden. Das heißt insbesondere: Die Plasmaelektroden sind wieder außerhalb der Prozessräume angeordnet, falls sie während der Hochtemperatur-CVD-Prozesse in Schritt S10 außerhalb der Prozessräume angeordnet waren, und liegen in jedem Fall wieder auf demselben Potential wie die übrigen Bestandteile der Vorrichtung, z.B. Masse. Auf die Aufnahmeplatten werden entweder keine Substrate aufgelegt oder es werden Konditionierungssubstrate aufgelegt. Konditionierungssubstrate entsprechen von ihren Abmessungen und Beschaffenheiten, z.B. Material, weitestgehend den während des Schritts S10 zu beschichtenden Substraten, werden jedoch nicht zu einem Endprodukt weiterbearbeitet. Die Aufnahmeplatten werden davor oder danach auf die erste Temperatur aufgeheizt und wenn diese erreicht ist, wird der erste Druck in den Prozessräumen eingestellt und dieselben Prozessgase wie in den Hochtemperatur-CVD-Prozessen in die Prozessräume zugeführt. Damit wird eine erste parasitäre Schicht, wie sie auch während der Beschichtungsvorgänge des Schrittes S10 abgeschieden werden, auf freiliegenden Bereichen der Aufnahmeplatte und des Gasverteilers sowie gegebenenfalls auf weiteren Bestandteilen der Vorrichtung erzeugt. Dadurch liegen bereits in einem ersten Hochtemperatur-CVD-Prozess, welcher nachfolgend ausgeführt wird, dieselben Umgebungsbedingungen in der Vorrichtung vor wie für darauffolgende weitere Hochtemperatur-CVD-Prozesse. Nach dem Ende des Beschichtungsvorganges des Konditionierungsprozesses werden die Konditionierssubstrate, falls sie verwendet wurden, aus der Vorrichtung entfernt.

Anschließend können wieder m Hochtemperatur-CVD-Prozesse wie in Schritt S10 ausgeführt werden, bevor wieder ein Reinigungs- und ein Konditionierungsprozess erforderlich sind. Dies ist durch den rückführenden Pfeil in Fig. 8 dargestellt.

### Bezugszeichen

- 1,1',1",1'": Vorrichtung zur chemischen Gasphasenabscheidung bei hohen Temperaturen
- 10,10a-10d: Paar aus Gasverteiler und Aufnahmeplatte
- 100a, 100b: Einheit aus hintereinander entlang einer Linie angeordneten Paaren
- 11. 11b. 11c: Gasverteiler
- 111: Gasvorratsraum
- 112: Gaskanal
- 113: Gasaustrittsoberfläche
- 12, 12a, 12b: Aufnahmeplatte
- 121: Grundkörper der Aufnahmeplatte
- 122: Heizer
- 123: Substrathalteoberfläche
- 13, 13a-13c: Prozessraum
- 14, 14a-14c: Einrichtung zur Wärmeisolation
- 141: Erstes Wärmeschutzblech
- 142: Zweites Wärmeschutzblech
- 143: Gasverteilerabschirmung
- 144: Wärmeisolationsschicht
- 145: Weitere Wärmeschutzanordnung
- 15, 15a, 15b: Versorgungseinheit
- 151: Zuführungsleitung
- 152a-152e: Auslassleitung
- 153: Zweistufiger Verteiler
- 1531: Verteilraum
- 1532: Block
- 1533: Einlassraum
- 1534: Auslassraum
- 1535: Durchlass
- 154: Binärer Verteiler
- 1541-1543: Teiler
- 1544-1549: Leitungen
- 17: Anordnung aus Gasverteiler und Aufnahmeplatte
- 171: Erster Bereich der Anordnung
- 172: Zweiter Bereich der Anordnung
- 18: Erste Gasabsaugeinrichtung
- 181a-181d: Gasabsaugöffnung der ersten Gasabsaugeinrichtung
- 182: Absaugoberfläche der ersten Gasabsaugeinrichtung
- 19: Zweite Gasabsaugeinrichtung
- 191a-191d: Gasabsaugöffnung der zweiten Gasabsaugeinrichtung
- 192: Absaugoberfläche der zweiten Gasabsaugeinrichtung
- 2: Prozesskammer
- 3: Substrat
- 4: Abstandshalter
- 5: Träger
- 6, 6a, 6b: Halterung

- A, Aa, Ab: Linie
- E1: Erste Ebene
- E2: Zweite Ebene
- M1: Mittelpunkt der Gasaustrittsoberfläche
- M2: Mittelpunkt der Substrathalteoberfläche
- h₁₀: Höhe eines Paares aus Gasverteiler und Aufnahmeplatte
- d: Abstand zwischen Gasverteiler und Aufnahmeplatte eines Paares

## Patentansprüche

1. Vorrichtung zur chemischen Gasphasenabscheidung bei hohen Temperaturen, aufweisend mehrere Paare bestehend aus je einem Gasverteiler und einer Aufnahmeplatte, wobei sich in jedem Paar der Gasverteiler und die Aufnahmeplatte gegenüberliegen und einen zugehörigen Prozessraum begrenzen, in jedem Paar der Gasverteiler geeignet ist, ein Gas in den Prozessraum einzuleiten, und in jedem Paar die Aufnahmeplatte geeignet ist, ein Substrat während der Gasphasenabscheidung zu halten, **dadurch gekennzeichnet, dass** alle Paare hintereinander entlang einer geraden Linie so angeordnet sind, dass die Linie in jedem Paar einer Verbindungslinie zwischen Gasverteiler und Aufnahmeplatte entspricht, wobei dabei die Gasverteiler und die Aufnahmeplatten alternierend angeordnet sind.

2. Vorrichtung nach Anspruch 1, **dadurch gekennzeichnet, dass** sich die Linie in vertikaler Richtung erstreckt und in jedem Paar der Gasverteiler oberhalb der Aufnahmeplatte angeordnet ist.

3. Vorrichtung nach Anspruch 1, **dadurch gekennzeichnet, dass** sich die Linie in horizontaler Richtung erstreckt.

4. Vorrichtung nach einem der Ansprüche 1 bis 3, **dadurch gekennzeichnet, dass** die Vorrichtung weiterhin mindesten eine Versorgungseinheit enthält, die sich entlang einer Richtung, die parallel zu der Linie, entlang der die Paare von Gasverteilern und Aufnahmeplatten angeordnet sind, verläuft, über mehrere Paare hinweg erstreckt und auf einer Seite der Prozessräume dieser Paare angeordnet ist, wobei die Versorgungseinheit geeignet ist, mindestens ein Medium aus der Gruppe umfassend ein Kühlmedium zum Kühlen des Gasverteilers, Prozessgase zur Durchführung der chemischen Gasphasenabscheidung, flüchtige Reaktionsprodukte, ein Heizmedium zum Heizen der Aufnahmeplatte, elektrischen Strom und elektrisches Potential, den Paaren von Gasverteilern und Aufnahmeplatten zur Verfügung zu stellen oder aus diesen oder den jeweiligen Prozessräumen abzuführen.

5. Vorrichtung nach Anspruch 4, **dadurch gekennzeichnet, dass** die Versorgungseinheit einen zweistufigen Verteiler enthält, wobei der Verteiler eine Zuführungsleitung zur Zuführung oder Abführung eines Mediums, einen Verteilraum und genau so viele Auslassleitungen wie Paare der Versorgungseinheit zugeordnet sind, aufweist, wobei im Verteilraum ein volumenreduzierender Block angeordnet ist, welcher den Verteilraum in einen Einlassraum, der mit der Zuführungsleitung verbunden ist, und einen Auslassraum, der mit den Auslassleitungen verbunden ist, unterteilt und eine Vielzahl von Durchlässen aufweist, welche den Einlassraum mit dem Auslassraum verbinden.

6. Vorrichtung nach Anspruch 4, **dadurch gekennzeichnet, dass** die Versorgungseinheit einen binären Verteiler enthält, wobei der Verteiler eine Zuführungsleitung zur Zuführung eines Mediums, mindestens einen Teiler und genau so viele Auslassleitungen wie Paare der Versorgungseinheit zugeordnet sind, aufweist, wobei jeder Teiler genau eine erste Leitung auf einer ersten Seite und genau zwei zweite Leitungen auf einer zweiten Seite aufweist, wobei die erste Seite der zweiten Seite entgegengesetzt ist, so dass das Medium, welches durch die erste Leitung in den Teiler gelangt, gleich auf die beiden zweiten Leitungen aufgeteilt wird, wobei der mindestens eine Teiler in n Ebenen zwischen der Zuführungsleitung und den Auslassleitungen angeordnet ist, wobei in einer ersten Ebene die Zuführungsleitung die erste Leitung des Teilers ist und in der n. Ebene die zweiten Leitungen die Auslassleitungen sind, und wobei jede zweite Leitung einer i. Ebene eine erste Leitung einer (i+1). Ebene ist, wobei i ∈ N und 1≤i≤n und n ∈ N und n≥1 gilt und wobei es genau 2ⁿ Auslassleitungen gibt.

7. Vorrichtung nach einem der Ansprüche 1 bis 3, **dadurch gekennzeichnet, dass** die Vorrichtung weiterhin zwei Gasabsaugeinrichtungen enthält, die sich jeweils mit ihrer absaugenden Oberfläche entlang einer Richtung, die parallel zu der Linie ist, über mehrere Paare hinweg erstrecken und auf gegenüberliegenden Seiten der Prozessräume angeordnet sind, wobei sie geeignet sind, aus den Prozessräumen der mehreren Paare ein Gas abzusaugen.

8. Vorrichtung nach einem der Ansprüche 1 bis 7, **dadurch gekennzeichnet, dass** die Vorrichtung zusätzlich eine Plasmaelektrode je Paar von Gasverteiler und Aufnahmeplatte enthält, wobei jede Plasmaelektrode geeignet ist, in dem zu dem Paar gehörigen Prozessraum ein Plasma zu zünden und aufrechtzuerhalten, wenn eine entsprechende Spannung zwischen der Plasmaelektrode und anderen Bestandteilen des Paares anliegt.

9. Vorrichtung nach Anspruch 8, **dadurch gekennzeichnet, dass** die Plasmaelektroden angrenzend an die Oberfläche des jeweils zugeordneten Gasverteilers, aus der die Prozessgase austreten, fest in der Vorrichtung angeordnet sind.

10. Vorrichtung nach Anspruch 8, **dadurch gekennzeichnet, dass** die Plasmaelektroden beweglich in der Vorrichtung angeordnet sind, so dass sie geeignet sind, in den jeweils zugeordneten Prozessraum hinein- oder aus diesem herausbewegt zu werden.

11. Vorrichtung nach einem der Ansprüche 1 bis 10, **dadurch gekennzeichnet, dass** die Gasverteiler fest in einer Prozesskammer angeordnet sind.

12. Vorrichtung nach Anspruch 11, **dadurch gekennzeichnet, dass** sich die Linie in vertikaler Richtung erstreckt und in jedem Paar der Gasverteiler oberhalb der Aufnahmeplatte angeordnet ist und dass ein Gasverteiler und eine Aufnahmeplatte, die zueinander benachbart angeordnet sind, jedoch nicht zum selben Paar gehören und nicht an denselben Prozessraum angrenzen, durch Abstandshalter voneinander beabstandet sind, wobei die Aufnahmeplatte über die Abstandshalter von dem Gasverteiler in vertikaler Richtung gehalten wird.

13. Vorrichtung nach einem der Ansprüche 1 bis 12, **dadurch gekennzeichnet, dass** die Aufnahmeplatten feststehend in der Prozesskammer angeordnet sind.

14. Vorrichtung nach einem der Ansprüche 1 bis 11, **dadurch gekennzeichnet, dass** ein Gasverteiler und eine Aufnahmeplatte, die zueinander benachbart angeordnet sind, jedoch nicht zum selben Paar gehören und nicht an denselben Prozessraum angrenzen, in einer gemeinsamen Anordnung ausgebildet sind.

15. Vorrichtung nach einem der Ansprüche 1 bis 14, **dadurch gekennzeichnet, dass** zwischen einem Gasverteiler und einer Aufnahmeplatte, die zueinander benachbart angeordnet sind, jedoch nicht zum selben Paar gehören und nicht an denselben Prozessraum angrenzen, eine Einrichtung zur Wärmeisolation angeordnet ist.

16. Vorrichtung nach einem der Ansprüche 1 bis 15, **dadurch gekennzeichnet, dass** alle hintereinander entlang einer Linie angeordneten Paare eine Einheit bilden und die Vorrichtung mehrere solche Einheiten enthält, wobei die einzelnen Einheiten lateral nebeneinander und/oder vertikal übereinander angeordnet sind derart, dass die Linien aller Einheiten parallel zueinander verlaufen.

17. Verfahren zum Betreiben einer Vorrichtung zur chemischen Gasphasenabscheidung bei hohen Temperaturen nach einem der Ansprüche 8 bis 10, wobei das Verfahren enthält:
- Ausführen einer Vielzahl von Prozessen zur chemischen Gasphasenabscheidung, wobei jeder Prozess das Auflegen von zu beschichtenden Substraten auf die Aufnahmeplatten, einen Beschichtungsvorgang und das Entfernen der Substrate von den Aufnahmeplatten enthält und wobei bei jedem Beschichtungsvorgang Prozessgase, die zur Abscheidung einer Schicht auf den Substraten geeignet sind, in die Prozessräume zugeführt und Prozessgase und flüchtige Reaktionsprodukte aus den Prozessräumen abgeführt, die Aufnahmeplatten auf einer ersten Temperatur, die Prozessräume bei einem ersten Druck und die Plasmaelektroden auf demselben Potential wie die übrigen Bestandteile der Vorrichtung gehalten werden,
- Ausführen eines Reinigungsprozesses nach dem Ausführen einer Vielzahl von Prozessen zur chemischen Gasphasenabscheidung, wobei ein fluor- und/oder chlorhaltige Prozessgas, das zur Entfernung einer Schicht von der Aufnahmeplatte und/oder dem Gasverteiler geeignet ist, in die Prozessräume zugeführt, die Aufnahmeplatten auf einer zweiten Temperatur und die Prozessräume bei einem zweiten Druck gehalten und die Plasmaelektroden mit einem Potential, das von dem Potential der übrigen Bestandteile der Vorrichtung verschieden ist und eine Frequenz größer Null aufweist, beaufschlagt werden, so dass in jedem Prozessraum ein Plasma gezündet und aufrechterhalten wird, und wobei die zweite Temperatur der Aufnahmeplatte kleiner als die erste Temperatur der Aufnahmeplatte und der zweite Druck kleiner als der erste Druck ist,
- Ausführen eines Konditionierungsprozesses, der nach dem Reinigungsprozess und vor dem Ausführen einer Vielzahl von Prozessen zur chemischen Gasphasenabscheidung stattfindet und einem solchen Prozess zur chemischen Gasphasenabscheidung entspricht mit dem Unterschied, dass keine zu beschichtenden Substrate oder statt den zu beschichtenden Substraten Konditionierungssubstrate aufgelegt und entfernt werden.

18. Verfahren nach Anspruch 17, **dadurch gekennzeichnet dass** die Vorrichtung zur chemischen Gasphasenabscheidung bei hohen Temperaturen eine Vorrichtung nach Anspruch 10 ist und das Verfahren weiterhin einen Schritt zum Hineinbewegen der Plasmaelektroden in die jeweils zugeordneten Prozessräume und einen Schritt zum Hinausbewegen der Plasmaelektroden aus den jeweils zugeordneten Prozessräumen enthält, wobei der Schritt zum Hineinbewegen unmittelbar vor dem Reinigungsprozess und der Schritt zum Hinausbewegen unmittelbar nach dem Reinigungsprozess ausgeführt werden.
